Europäisches Patentamt

European Patent Office

Office européen des brevets

(19)

(11) EP 1 349 092 A2

## (12) EUROPEAN PATENT APPLICATION

(43) Date of publication:
01.10.2003 Bulletin 2003/40

(51) Int Cl.7: G06F 17/50

(21) Application number: 03251837.5

(22) Date of filing: 24.03.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 22.03.2002 US 102749

(71) Applicant: NEC Corporation
Minato-ku, Tokyo 108-8001 (JP)

(72) Inventors:
• Cadambi, Srihari
Princeton, New Jersey 08540 (US)
• Ashar, Pranav
Bellmead, New Jersey 08502 (US)

(74) Representative: Abnett, Richard Charles et al
REDDIE & GROSE
16 Theobalds Road
London WC1X 8PL (GB)

### (54) A hardware acceleration system for logic simulation

(57)    A hardware acceleration system for functional simulation comprising a generic circuit board including logic chips, and memory. The circuit board is capable of plugging onto a computing device. The system is adapted to allow the computing device to direct DMA transfers between the circuit board and a memory associated with the computing device. The circuit board is further capable of being configured with a simulation processor. The simulation processor is capable of being programmed for at least one circuit design.

Fig. 3

EP 1 349 092 A2

**Description**

## I. DESCRIPTION

### *Field*

This invention relates to a hardware acceleration system for functional simulation of circuits, and to a method for performing logic simulation for a circuit.

Specifically, systems and methods using a simulation processor are proposed. Methods for compiling a netlist for the simulation processor are also discussed.

### *Background*

### 1. References

The following papers provide useful background information, for which they are incorporated herein by reference in their entirety, and are selectively referred to in the remainder of this disclosure by their accompanying reference numbers in pointed brackets (i.e., <4> for the fourth numbered paper by J. Abke et al.):

<1> http: //www.quickturn.com/products/speedsim. htm.

<2> http: //www.quickturn.com/products/palladium. htm.

<3> 2001. http: /www.quickturn.com/products/Co BALTUItra.htm.

<4> Joerg Abke and Erich Barke. A new placement method for direct mapping into LUT-based FPGAs. In International , Conference on Field Programmable Logic and Applications (FPL 2001), pages 27 - 36, Belfast, Northern Ireland, August 2001.

<5> Semiconductor Industry Association. International technology roadmap for semiconductors. 1999. http: //public.itrs.net.

<6> Jonathan Babb, Russ Tessier, and Anant Agarwal. Virtual wires: Overcoming pin limitations in FPGA-based logic emulators.
In Proceedings of the IEEE Workshop on FPGAs for Custom Computing Machines, April 1993.

<7> Jonathan Babb, Russ Tessier, Matthew Dahl, Silvina Hanono, David Hoki, and Anant Agarwal. Logic emulation with virtual wires. In IEEE Transactions on CAD of Integrated Circuits and Systema, June 1997.

<8> Steve Carlson. A new generation of verification acceleration. June. http: //www.tharas.com.

<9> M. Chiang and R. Palkovic. LCC simulators speed development of synchronous hardware. In Computer Design, pages 87-92, March 1986.

<10> Seth C. Goldstein, Herman Schmit, Matt Moe, Mihai Budiu, Srihari Cadambi, R. Reed Taylor, and Ronald Laufer., Piperench: A coprocessor for streaming multimedia acceleration. In The 26th Annual International Symposium on Computer Architecture, pages 28-39, May 1999.

<11> S. Hauck and G. Borriello. Logic partition orderings for multi-FPGA systems. In ACM/SIGDA International Symposium on Field Programmable Gate Arrays, pages 32-38, Monterey, CA, February 1995.

<12> Chandra Mulpuri and Scott Hauck. Runtime and quality tradeoffs in FPGA placement and routing. In International Symposium on Field Programmable Gate Arrays, pages 29 - 36, Napa, CA, February 2001.

<13> Alberto Sangiovanno-Vincentelli and Jonathan Rose. Synthesis methods for field-programmable gate arrays. In Proceedings of the IEEE, Vol. 81, No. 7, pages 1057-83, July 1993.

<14> E. Shriver and K. Sakallah. Ravel: Assigned-delay compiled-code logic simulation. In International Conference on Computer-Aided Design (ICCAD), pages 364-368, 1992.

<15> D. Thomas and P. Moorby. The Verilog Hardware Description Language, 3rd Edition. Kluwer Academic Publishers, 1996.

<16> S. Trimberger. Scheduling designs into a time-multiplexed FPGA. In Proceedings of the 1998 ACM/SIGDA Sixth International Symposium on Field Programmable Gate Arrays, February 1998.

<17> S. Trimberger, D. Carberry, A. Johnson, and J. Wong. A time-multiplexed FPGA. In IEEE Symposium on FPGAs for Custom Computing Machines (FCCM) 1997, February 1997.

<18> Keith Westgate and Don McInnis. Reducing simulation time with cycle simulation. 2000. http: //www.quickturn.com/tech/cbs.htm.

<19> J. Cong and Y. Ding. An Optimal Technology Mapping Algorithm for Delay Optimization in Lookup-Table based FPGA Designs. In IEEE Transactions on CAD, pages 1-12, January 1994.

<20> F. Corno, M. S. Reorda, and G. Squillero. RT-level ITC99 Benchmarks and First ATPG Results. In IEEE Design and Test of Computers, pages 44-53, July 2000.

<21> Xilinx. Virtex-II 1.5v Field Programmable Gate Array:

Advance Product Specification. Xilinx Application Databook, October 2001. http: //www.xilinx.com/partinfo/databook.htm.

## 2. Introduction

### a) The Verification Gap

New applications and processing demands have substantially increased the complexity and density of integrated circuits (ICs) over the past decade. Growing market pressures necessitate fast design cycles implying an increased reliance on fully automated design methodologies. Functional verification is an important part of such a design methodology. It plays a critical role in determining the overall time-to-market of a design: the amount of functional verification that designers have to perform before they incur the time and expense of manufacture is large. More than 60% of human and computer resources are used for verification in a typical design process[1], of which more than 85% are for functional verification[5]. While the complexity and density of chips have scaled sharply over the past few years (and are expected to similarly scale over the next decade as well), the ability to verify circuits has not, i.e., the performance of CAD tools for functional verification does not scale well with circuit complexity.

The resulting "functional verification gap" has been addressed to some extent by the use of hardware-assisted simulators as well as specialized hardware emulators. Specialized emulators offer a considerable performance gain when compared to software simulators, albeit at a much higher cost. The process of software simulation itself was, until recently, based on event-driven simulation. However, a breakthrough was achieved a few years ago with the arrival of cycle-based logic simulators.

### b) Cycle-based Simulation

Cycle-based simulation is different from traditional event-driven simulation, and is highly suitable for functional verification. Event-driven simulators update outputs of gates at the inputs of which events occur. They then schedule future events for every gate affected by these updates. This is efficient for circuits with low activity rates, since only a small fraction of the total number of gates will need to be updated each cycle. This also allows event-driven simulators to model and simulate gate delays. However, it increases memory usage and slows down the simulation for large circuits that have high activity rates.

Cycle-based simulation presents a faster and less memory-intensive method of performing functional verification. It is characterized by the following:

• Values are computed only at clock edges, that is, intermediate gate results are not computed. Instead, outputs at each clock cycle are computed as Boolean logic functions of the inputs at that clock cycle.

• Combinational timing delays are ignored.

• Usually, the simulation is 2-valued (0, 1 states) or 4-valued (0, 1, x and z states). A full event-driven simulator will have to support upto 28 states.

Cycle-based simulators thus achieve better performance by focussing on functional verification. For practical circuits, they are around 10 times faster than event-driven simulators and have around one-fifth the memory usage[18]. For instance, the commercial cycle-simulator SpeedSim (from Quickturn/Cadence), can simulate a 1.5 million gate netlist at 15 vectors per second on a standard UltraSparc workstation. Rates for netlists with 50-100,000 gates are usually around 4-500 vectors per second. As a result, such simulators are becoming increasingly popular in design verification.

### c) Hardware-assisted Cycle-based Simulation

In order to further enhance its speed, cycle-based simulations may be accelerated by means of specialized hardware. They are promising candidates for hardware acceleration owing to the presence of considerable concurrency (or instruction-level parellelism) which cannot be exploited by traditional microprocessors. With the advent of electrically reconfigurable Field Programmable Gate Arrays (FPGAs), inexpensive hardware solutions can be devised. Reconfigurability allows a logic circuit to be emulated on the FPGA, thereby handling the concurrency using spatial parallelism. Such an approach can significantly accelerate functional verification and improve the design time and time-to-market of complex designs.

Although a single FPGA has the ability to emulate several different logic designs, it is limited in size and cannot accommodate a large circuit all at once, i. e., a circuit that needs more resources than available in the FPGA will not fit.

An obvious workaround for this problem is to use multiple FPGAs. However, a multi-FPGA emulation system is neither scalable nor cost-effective. For instance, a system that consists of 10 FPGAs is of little use when designs get larger than the 10 FPGAs combined. Also, the limited number of pins connecting the FPGAs are a bottleneck that result in poor logic utilization, leading to several partially used FPGAs. Further, these pins use the relatively slow on-board interconnection wires, which reduces emulation speeds<11>. These problems have been addressed to some extent with the VirtualWires concept from MIT<6,7>. However, several emulation vendors (such as Axis) still use several FPGAs and specially designed hardware within systems costing hundreds of thousands to millions of dollars.

Another approach to emulation is to time-multiplex large designs onto physically smaller FPGAs. The circuit is not emulated as a whole, but in portions: each portion fits inside the single FPGA, which is repeatedly reconfigured. While this does not have the pin limitations and the high cost of the multi-FPGA solution, its performance is adversely affected by the FPGA's reconfiguration overhead. Most generic FPGAs are not tailored to be reconfigured very often, and hence dedicate only a small number of I/O pins for configuration purposes. Thus they have a very small configuration bandwidth which results in significant delays during reconfiguration. Specialized FPGA architectures with extra on-chip storage for multiple configuration contexts have been devised<16,17>. However, such architectures are neither commercially available nor scalable.

### 3. Background to the technology and related work

In this section, we discuss several aspects of related work, including background and conventional technologies.

### 4. Simulation Techniques

In event-driven simulation, a changing value on a net is considered an event. Events are managed dynamically by an event scheduler. The event scheduler schedules an event and updates every net whose value changes as a response to the scheduled event. It also schedules future events resulting from the scheduled event<15>. The main advantage of event-driven scheduling is flexibility; event-driven simulators can simulate both synchronous and asynchronous models with arbitrary timing delays. The disadvantage of event-driven simulation is low simulation performance owing to its inherently serial nature and large memory usage.

Levelized compiled code logic simulators (from which cycle-based simulators were derived) have the potential to provide much higher simulation performance than event-driven simulators because they eliminate much of the run-time overhead associated with ordering and propagating events. This is done by evaluating all components once each clock cycle in topological order which ensures all inputs to a component have their latest value by the time the component is executed. The main disadvantage of cycle-based simulators is that they cannot simulate with arbitrary gate delays (<14> is a notable exception).

Until a few years ago, event-driven simulators were generally preferred over cycle-based simulators since most circuits had activity rates in the range of 1-20%<9>. The performance of event-driven simulators is a function of circuit activity rather than the circuit size. The entire circuit is not statically compiled; rather, the simulation proceeds by interpretation, during which only those gates and nets affected by circuit activity are updated. On the other hand, in cycle-based simulation, every gate in the circuit is evaluated every cycle since the entire circuit is statically compiled before the start of simulation. Another reason for the earlier popularity of event-driven simulators is that they could check circuit functionality and timing together. However, with the advent of static timing analysis tools, functionality and timing can now be verified separately.

Modern applications (such as those in the multimedia and networking domains) and techniques such as pipelining and parallel execution have resulted in circuits with significantly higher activity rates. When gate delays are not required (i.e., for functional verification) cycle based simulators are preferred over event-driven simulators. Despite the fact that cycle-based simulators simulate the entire circuit, they outperform event-driven simulators owing to their low memory usage and parallelizable nature<14,18>.

The disclosed techniques relate to a scalable hardware accelerator for cycle-based simulation using a generic board with a single commercially available FPGA. In the rest of this section, we discuss other FPGA-based hardware accelerators including commercial offerings of potential competitors in the field.

### a) Single FPGA Systems

Using a single FPGA for logic emulation has two major problems:

- Lack of scalability: Designs that do not fit in the FPGA cannot be emulated as a whole. Emulating such designs in parts require repeated reconfiguration which is very time consuming on commercial FPGAs.

- Long compilation time: Conventional FPGA tool flow is complex and can take several hours to a few days for large designs. This adds to the simulation overhead and can seriously impact the design time and time to market.

In <17>, the authors present a time-multiplexed FPGA architecture that can hold multiple contexts with fast switching between contexts. A large circuit that does not fit in the FPGA can be partitioned into smaller portions that fit, and each portion may be stored inside the FPGA. While this solution circumvents the cumbersome repeated reconfiguration, it is affected by the amount of context storage provided in the FPGA.

Further, commercial FPGAs cannot store and switch between multiple contexts, so specialized FPGAs will have to be built.

### b) Multiple FPGA Systems

Emulation systems typically consist of a number of commercial FPGAs interconnected together. While this allows large designs to be emulated, the utilization of each FPGA can be seriously affected by the limited number of pins available for inter-FPGA communication. Scarcity of pins can cause FPGAs to be partially filled resulting in wastage. <6> proposed a novel technique called "Virtual Wires", where each physical pin was time-multiplexed and mapped to several "virtual pins" in the design. This is done with some additional time-multiplexing hardware, but the entire design had to be emulated at a clock rate lower than the FPGA clock rate. Nevertheless, the Virtual Wires concept is highly suitable for systems with multiple FPGAs.

### c) Commercial Offerings

(1) Quickturn/Cadence

Quickturn (now incorporated into Cadence) has marketed cycle-based simulators, simulation accelerators and emulators.
SpeedSim is a (software) cycle-based verilog simulator that directly converts hardware description language (HDL) into native machine code. Its performance is enhanced by the use of Symmetric Multi-Processing (SMT) and
Simultaneous Test (ST) techniques with which multiple test vectors may be simulated within a single design<1>.
One of Quickturn's comprehensive verification products used for simulation acceleration, testbench generation and in-circuit emulation is Palladium<2>. Palladium is constructed using specialized ASICs that are tailored for simulation and emulation. A much larger emulation system from Quickturn is CoBALT<3>, which is scalable upto 112 million gates. All of these products require an entire specially designed system, and are therefore very expensive (in the range of millions of dollars).

(2) Tharas Systems

Tharas Systems provides a more affordable verification acceleration system called Hammer. The Hammer hardware consists of a high bandwidth backplane connected to a board with several proprietary, custom built ASICs. The ASICs can evaluate a portion of an RTL or gate-level design and also provide a non-blocking interconnect mechanism<8> with all other ASICs on the board. The system is expandable upto 8 million gates and costs around a few hundred thousand dollars.

(3) IKOS

IKOS (http: //www.ikos.com) markets the VirtuaLogic and VStation emulation systems. VirtuaLogic comprises hardware consisting of several FPGAs connected together using the Virtual Wires concept<6>. VStation is a larger emulator that can be connected to a workstation using IKOS' special interface called the Transaction Interface Portal. The IKOS systems primarily target the emulation market.

(4) AXIS

The Xtreme simulation acceleration system marketed by AXIS (http: //www.axiscorp.com) is again composed of several FPGAs. Coupled with the software simulator Xcite, the AXIS systems provide the ability to "hot-swap" between hardware and software, i.e., hardware-accelerated simulation could be employed until a design bug is encountered, at which point the entire design is efficiently swapped into software for debugging.

(5) Others

Avery Design Systems markets a product called the SimCluster, which may be used to distribute verilog simulation efficiently among multiple CPUs. It may be independently licensed and used with third party verilog simulators as well. Another company, Logic Express offers the SOC-V20 product which again consists of several FPGAs along with some hardwired logic tailored for simulation acceleration.

### II. SUMMARY

The disclosed teachings are aimed at overcoming some of the disadvantages and solving some of the problems noted above in relation to conventional technologies. Specifically, the disclosed techniques provide at least four advantages: (i) low cost, (ii) high performance, (iii) low turn-around-time, (iv) scalability. It exhibits the cost, scalability and turn-around-time of simulators but has performance that is orders of magnitude larger.
To realize the advantages noted above, there is provided a hardware acceleration system for functional simulation comprising a generic circuit board including logic chips, and memory. The circuit board is capable of plugging onto a computing device. The system is adapted to allow the computing device to direct DMA transfers between the circuit board and a memory associated with the computing device. The circuit board is further capable of being configured with a simulation processor. The simulation processor is capable of being programmed for at least one circuit design.
In another specific enhancement, an FPGA is mapped with the simulation processor.
In another specific enhancement, a netlist for a circuit to be simulated is compiled for the simulation processor.

In another specific enhancement, the simulation processor further includes: at least one processing element; and at least one register file with one or more registers corresponding to said at least one processing element.

In another specific enhancement, the simulation processor further includes a distributed memory system with at least one memory bank.

In another specific enhancement, said at least one memory bank serves a set of processing elements and their associated registers.

In another specific enhancement, a register is capable of being spilled onto the memory bank.

In another specific enhancement, the system further includes an interconnect system that connects said at least one processing element with other processing elements.

In another specific enhancement, the processing element is capable of simulating any 2-input gate.

In another specific enhancement, the processing element is capable of performing RT-level simulation.

In another specific enhancement, the connection is made through the registers.

In another specific enhancement, the interconnect network is pipelined.

In another specific enhancement, the register file is located in proximity to its associated processing element.

In another specific enhancement, the distributed memory system has exclusive ports corresponding to each register file.

In another specific enhancement, the system is capable of processing a partition of the netlist at a time when the netlist is does not fit the memory on the board.

In another specific enhancement, the system is capable of simulating the entire netlist by sequentially simulating its partitions.

In another specific enhancement, the system is capable of processing a subset of simulation vectors that are used to test the circuit.

In another specific enhancement, the system is capable of simulating the entire set of simulation vectors by sequentially simulating each subset.

In another specific enhancement, the acceleration system is capable of being interchangeably used with a generic software simulator with the ability to exchange the state of all registers in the design.

In another specific enhancement both 2-valued and 4-valued simulation can be performed on the simulation processor.

In another specific enhancement, the system further includes an interface and opcodes, wherein said opcodes specify reading, writing and other operations related to simulation vectors.

In another specific enhancement, the simulation processor further includes at least one arithmetic logic unit; zero or more signed multipliers; a distributed register system with least one register each associated with said ALU and said multiplier.

In another specific enhancement, the system includes a carry register file for each ALU, wherein a width of the register is same as a width of the corresponding register.

In another specific enhancement, the system further includes a pipelined carry-chain interconnect connecting the registers.

In another aspect, there is provided a method for performing logic simulation for a circuit comprising: compiling a netlist corresponding to the circuit to generate a set of instructions for a simulation processor; loading the instructions onto the on-board memory corresponding to the simulation processor; transferring a set of simulation vectors onto the on-board memory; streaming a set of instructions corresponding to the netlist to be simulated onto an FPGA on which the simulation processor is configured; executing the set of instructions to produce a set of result vectors; and transferring the result vectors onto a host computer.

In yet another aspect of the disclosed teachings, there is provided a method of compiling a netlist of a circuit for a simulation processor, said method comprising: representing a design for the circuit as a directed graph, wherein nodes of the graph correspond to hardware blocks in the design; generating a ready-front subset of nodes that are ready to be scheduled; performing a topological sort on the ready-front set; selecting a hitherto unselected node; completing an instruction and proceeding to a new instruction if no processing element is available; selecting a processing element with most free registers associated with it to perform an operation corresponding to the selected node; routing operands from registers to the selected processing element; and repeating until no more nodes are left unselected.

## III. BRIEF DESCRIPTION OF THE DRAWINGS

The above objectives and advantages of the disclosed teachings will become more apparent by describing in detail preferred embodiments thereof with reference to the attached drawings in which:

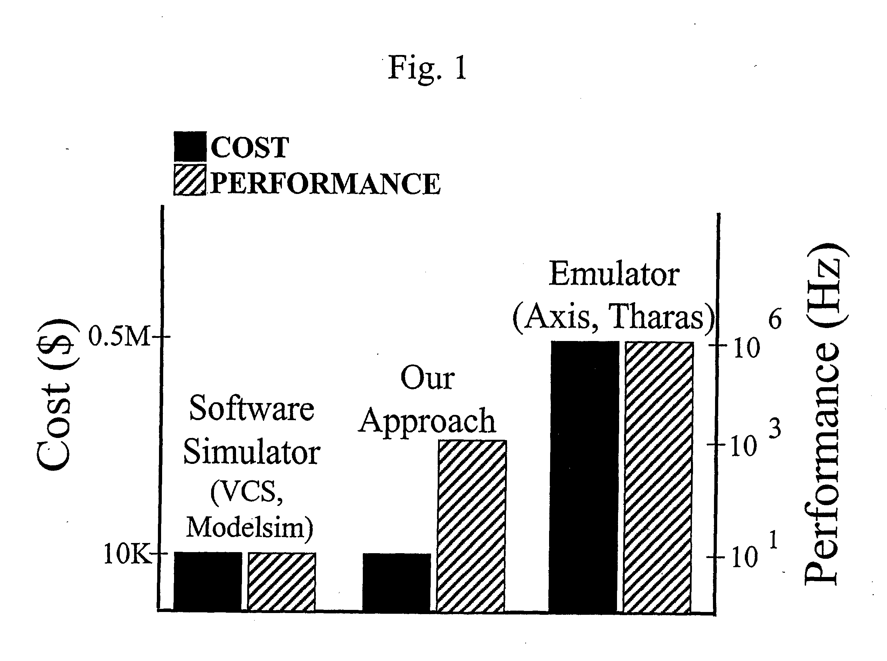

FIG.1 shows a cost and performance comparison between systems using the disclosed teachings and conventional simulators and emulators.

FIG. 2 shows a scheme for simulating a large netlist on a single FPGA using the example SimPLE intermediate architecture.

FIG.3 shows an overall system methodology according to the disclosed techniques.

FIG.4 shows an example of an architectural model of SimPLE with 4 processing elements, 2 memory banks, 4-wide register files with two read ports each and a crossbar.

FIG. 5 shows a maximum number of intermediate values for netlists when scheduled using the ASAP heuristic.

FIG. 6 depicts a flowchart showing an example compiler that performs scheduling and instruction generating.

FIG. 7 shows an example of node selection for scheduling.

FIG. 8 shows an example of spillig a register into memory.

FIG. 9 shows an example of loading the inputs of a node in the ready-front.

FIG. 10 shows an example of handling user-specified registers.

FIG. 11 shows allocation of primary input and primary output bits to specific slots in the memory system.

FIG.12 is a graph depicting storage requirements for an example SimPLE implementation.

FIG.13 is a graph showing the compilation speed for an example SimPLE implementation.

FIG.14 is graph depicting the effect of increasing register ports on compilation efficiency. The X-axis depicts P-r where P is the number of processors and r the number of registers in example SimPLE implementations.

FIG.15 is a graph showing the effect of increasing register ports on virtex-II CLB usage. The X-axis depicts P-r where P is the number of processors and r the number of registers in example SimPLE implementations.

FIG.16 shows a hierarchy of a SimPLE implementation, showing the largest repeating unit.

FIG.17 shows a table that shows improvements in FPGA clock speed of SimPLE using regularity-driven placement.

FIG.18 shows simulation rate in vecotrs per second for various example SimPLE implementations.

FIG.19 shows a tool flow for a software implementation of cycle-based simulation and to simulate a gate-level netlist using SimPLE.

FIG. 20 shows a speedup of SimPLE over a cycle-based simulator.

FIG. 21 shows a speedup of simple over ModelSim.

FIG. 22 shows an architecture for RTL-level circuits

## IV. DETAILED DESCRIPTION

### IV.A. *Hardware Acceleration System*

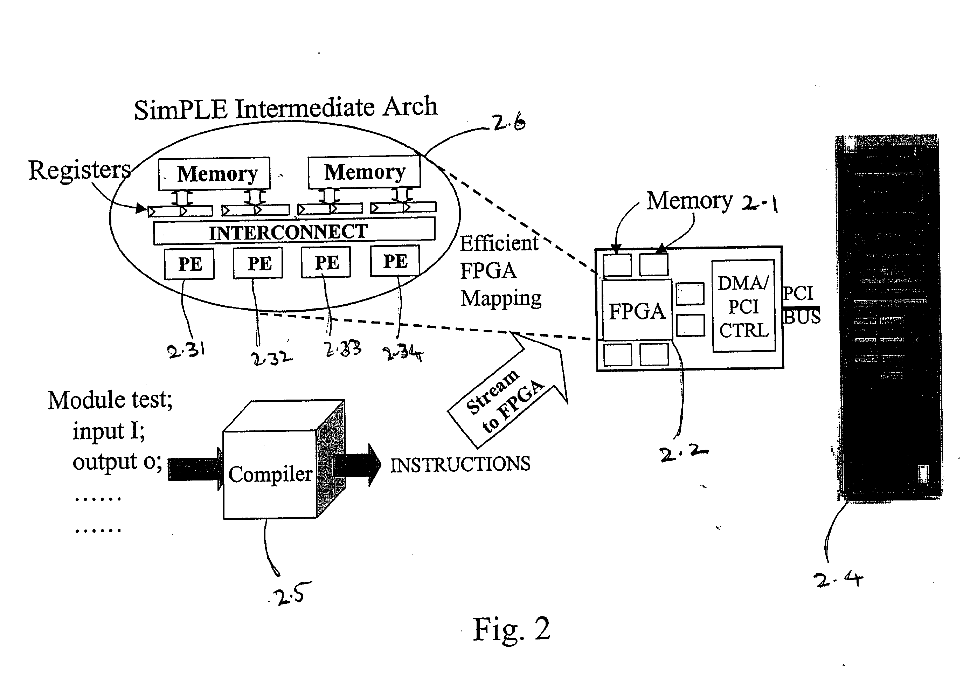

In this section, an overall hardware acceleration system that is an example implementation that utilizes the disclosed techniques is described. SimPLE 2.6 (shown in FIGs.2-4, for example) is a nonlimiting example implementation of the disclosed techniques related to the simulation processor. It should be clear that the specific architectures and implementations described here are merely examples and should not be construed to limit the claimed invention in any way. A skilled artisan would know that many alternate implementations are possible without deviating from the scope of the disclosed techniques. Further, even though the examples are described using an FPGA, it should be clear that any logic chip could be used.

Time-multiplexing netlists on FPGAs normally incurs a large configuration overhead since most FPGAs dedicate few pins for configuration bits. We solve this configuration bandwidth problem by introducing the notion of a simulation processor. An example of such a simulation processor, entitled SimPLE, is described herein in greater detail.

SimPLE is a virtual concept to which a netlist is compiled. After being configured on the FPGA once, it is programmed for different circuit designs (i.e., different netlists may be simulated on it) using an example compiler, called the SimPLE compiler. The instructions for SimPLE use the data I/O pins of the FPGA and are not affected by the small configuration bandwidth.

### 1. The Example overall system

The described overall hardware acceleration system consists of a generic PCI-board with a commercial FPGA, memory and PCI and DMA controllers, so that it naturally plugs into any computing system. The board is assumed to have direct access to the host's memory, with its operation being controlled by the host. Thus, the host can direct DMA transfers between the main memory and the memory on the board, which the FPGA can access. Further, with the disclosed techniques, the board memory need only be single-ported with either the FPGA or the host (via the PCI interface) accessing it at any time.

FIG. 2 shows our simulation methodology. The compiled SimPLE instructions for a circuit are transferred to the on-board memory 2.1 along with a set of simulation vectors using DMA. Each instruction specifies operations for every processing element (PE) 2.31-2.34 in SimPLE, and represents a slice of the netlist.

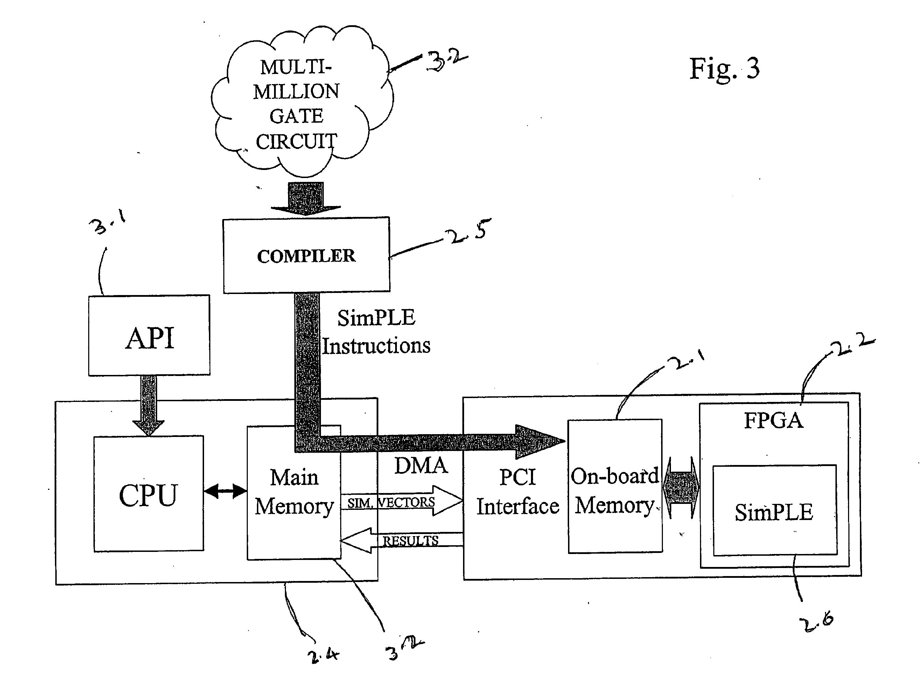

Executing all instructions simulates the entire netlist for one simulation vector. For each simulation vector therefore, all the instructions are streamed from the board memory to the FPGA 2.2 after which the result vector is stored back in the on-board memory 2.1. If the SimPLE instruction is wider than the FPGA-memory bus on the board, it is time-multiplexed into smaller pieces that are reorganized using extra hardware on the FPGA. When all the simulation vectors are done, the result vectors are DMA'ed back from the board to the host 2.4. More simulation vectors may now be simulated if required. The host controls the entire simulation is through an API 3.1 (shown in FIG.3).

In order to quantify the simulation speed, we define user cycles, processor cycles (similar to the definitions provided in <16>) and FPGA cycles. The FPGA cycle is the clock period of the FPGA with SimPLE configured on it. A processor cycle is the rate at which SimPLE operates. It is defined as the time taken to complete a single SimPLE instruction. Usually, since an instruction completes every FPGA cycle, the processor cycle is the same as the FPGA cycle. However, if the instruction is time-multiplexed (i.e., when the SimPLE instruction is wider than the FPGA-memory bus), the processor cycle is larger than the FPGA cycle. For instance, if the SimPLE instruction is twice as wide as the FPGA-memory bus, the processor cycle is twice the FPGA cycle. Finally, a user cycle is the time taken to fully simulate the netlist for a single simulation vector, i.e., process all the instructions.

We can now quantify the simulation rate. Assume the SimPLE compiler produces N instructions for a netlist when targeting a SimPLE architecture whose instruction width is IW. If the FPGA-memory bus width is BW and the FPGA clock cycle is FC, then the user cycle UC and simulation rate R are given by

$$U_c = N \times \left\lceil \frac{I_w}{B_w} \right\rceil \times F_c \qquad (1)$$

$$R = 1/U_c \qquad (2)$$

Thus the simulation rate can be increased by reducing (i) the number of instructions produced by the compiler, (ii) the instruction width and (iii) the FPGA clock cycle.

If a very large circuit compiles to too many instructions that do not fit in the on-board memory, the instructions are broken up into smaller portions and DMAed separately. This affects the overall performance but maintains the scalability of SimPLE. By upgrading the on-board memory however, we can achieve scalability with no loss of performance. Reasonable amounts of memory allow very large netlists to be simulated: a board with 256MB of SDRAM, for instance, can hold all instructions for a 50-million gate netlist.

One of the goals of the disclosed techniques, specifically SimPLE, is to devise an inexpensive hardware accelerator for which a generic logic chip, for example an FPGA board, may be used. The board consists of a commercial FPGA, memory and a PCI interface, so that it is "plug-and-play" compatible with practically any computing system. It is assumed to have direct access to main memory, but its operation controlled by the host CPU.

FIG. 3 shows another example of our methodology. The compiled instructions for a circuit 3.2 are transferred into the on-board memory 2.1 along with a set of simulation vectors using DMA. For each simulation vector thereafter, all the instructions are streamed through the FPGA 2.2 representing one user-cycle, or one simulation cycle, and the corresponding result vector is stored back in the board memory. When all the simulation vectors are done, the result vectors are DMA'ed back to the host memory space 3.2. If more test vectors are present, they may now be simulated as well.

If a very large circuit compiles to too many instructions that do not fit in the on-board memory, we break up the instructions into smaller portions and DMA them separately. This affects the overall performance but maintains the scalability of SimPLE. By upgrading the on-board memory however, we can achieve scalability with no loss of performance. A board with 256MB of DRAM for instance will allow simulation of 20 million gate netlists.

In the following sections, we describe the process of instruction and simulation vector transfer and the interface software necessary to perform the hardware simulation.

### a) Instruction transfer

While most configurations of SimPLE easily fit in a large Virtex-2 FPGA, some have large instruction words. For instance, a simulation processor with 64 processors, 64 registers, 2 register read ports and 32 16K memory blocks requires 3080 bits per instruction. The data pinout of the largest Virtex-2 FPGA is around 1100. Therefore, the instructions must be time-multiplexed, and transferred into the FPGA in multiple processor cycles. The HDL generator takes care of this, and generates special hardware to enable time-multiplexing of instructions. This extra hardware is part of the SimPLE architecture and is specific to the FPGA package that is present on the board.

### b) Simulation Vector transfer

The set of values comprising the primary inputs of the netlist being simulated represents the simulation vector. In order to verify the functionality of the netlist, several simulation vectors are typically used. For each vector, an output vector or result vector is computed by the simulation. Thus, SimPLE has to handle three different kinds of "board-level" instructions: those that represent a simulation vector, those that represent actual SimPLE instructions generated by the SimPLE compiler and a special instruction during which an output result vector is read.

Primary inputs (PIs) are written from the on-board memory to the local scratchpad memory within SimPLE and then accessed by the processing elements. Similarly, primary outputs (POs) are written by the processing elements within SimPLE to the scratchpad memory and then read out to the on-board memory.

Large gate-level circuits have several hundred simulation vector bits. Transferring these simulation vectors may also require time-multiplexing. Unlike in the case of time-multiplexing instruction words, the extent of time-multiplexing required for a simulation vector is dependent on the netlist. Since the SimPLE architecture must be independent of the netlist being simulated, no special hardware can be present on SimPLE to time-multiplex the simulation vectors. Instead, the SimPLE interface software, described in the next section, takes care of this. In each cycle, the input simulation vectors are loaded directly from the on-board memory to the scratchpad memory within SimPLE (on the FPGA). The maximum number of bits that may be loaded into the scratchpad memory is equal to the total memory bandwidth. If the length of the simulation vector is larger than the maximum memory bandwidth, the interface software breaks up the simulation vector into smaller words each equal to the memory bandwidth. Each simulation vector is appended with an appropriate opcode that identifies it.

A similar procedure takes care of the primary outputs; they are off-loaded from the FPGA at a rate equal to the memory bandwidth.

### c) SimPLE Interface Software

The interface software takes as input the simulation vectors specified by the user and SimPLE instructions generated by the compiler, and generates board-level instructions. These instructions are DMA'ed onto the on-board memory using the API provided with the FPGA board.

The board-level instructions distinguish between input and output simulation vectors and actual simulation processor instructions. There are three opcodes for identifying these three cases. The opcode bits are padded in front of the input simulation vector bits or SimPLE instruction bits in order to create the board-level instruction. If the opcode indicates an output simulation vector, then the rest of the instruction bits are read out from SimPLE using tristate buses.

In addition to padding with the appropriate opcode bits, the interface software also organizes the primary input and output vectors. The simulation vectors are specified by the user in order. However, since they are directly transferred into the scratchpad memory blocks of SimPLE, the bits are reorganized based on the memory configuration. The POs coming out of SimPLE are similarly reorganized to create the final result vector.

### IV.B. Architecture

In this section, we focus on the problem of simulating a large design using a single, generic FPGA. FPGAs are usually not large enough to emulate multi-million gate netlists. The netlists first need to be partitioned into pieces that fit on the device. Thereafter, by repeated reconfiguration of the FPGA, the partitions may be simulated sequentially. While this solution is scalable with the size of the netlist, the high reconfiguration overhead in FPGAs (because of the small configuration bandwidth) makes it impractical.

We solve the configuration bandwidth problem by introducing the notion of a simulation processor for logic emulation (SimPLE). SimPLE is a virtual concept to which a netlist is compiled. After being configured onto the FPGA once, it is programmed for different designs (or different portions of a design) using the SimPLE compiler. The instructions for SimPLE use the data I/O pins of the FPGA and are not affected by the small configuration bandwidth.

### 1. SimPLE Architecture

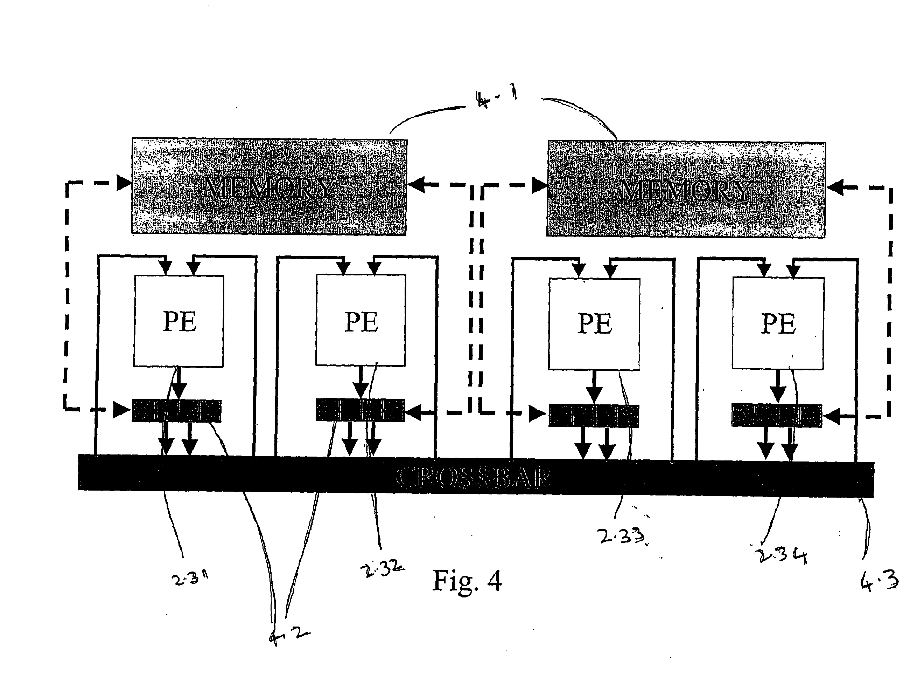

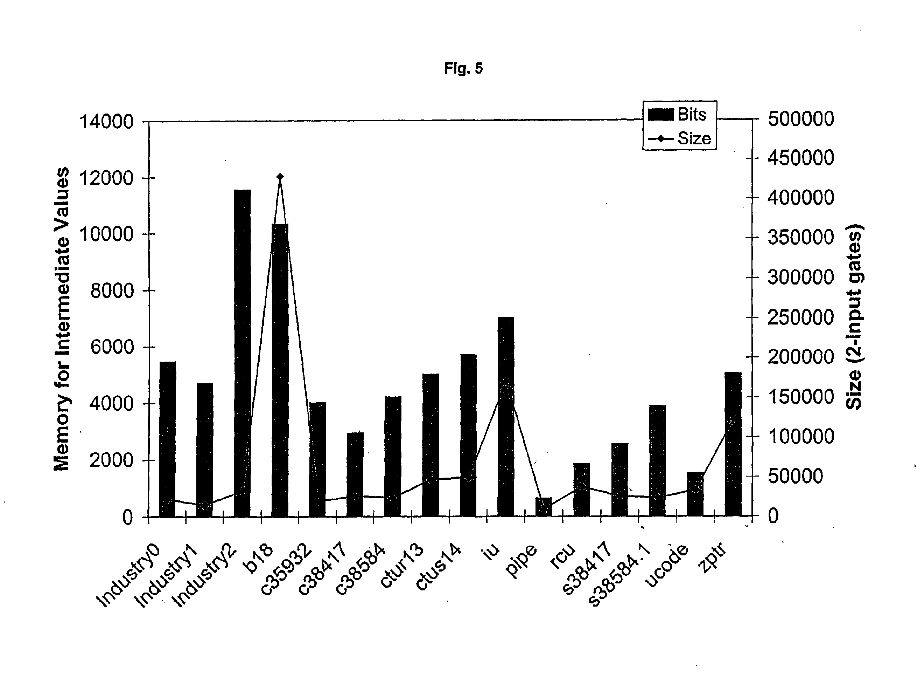

SimPLE is based on the VLIW architectural model. Such an architecture can take advantage of the abundant inherent parallelism present in gate-level netlist simulations. A template of SimPLE is shown in FIG. 4. It consists of a large array of very simple interconnected functional units or processing elements 2.31-2.34. Each processing element can simulate any 2-input gate. Every cycle, a large number of gates may thus be simultaneously evaluated. In order to store intermediate signal values, it has a distributed register file system 4.2 that provides considerable accessibility at high clock speeds. In addition, since the number of registers is limited by hardware considerations (as FPGAs are not register-rich), there is a second-level of memory hierarchy in the form of a distributed memory system 4.1 that permits registers to be spilled. In other words, registers may be loaded from and stored into memory. The presence of multiple memory banks permits fast simultaneous accesses. The number of intermediate signal values that may be stored is limited only by the total memory size, which can be quite large in modern FPGAs. For instance, the total size of the block RAM in a large Virtex-II is about 3.5 million bits. FIG. 5 shows the maximum number of intermediate values required for typical netlists for an ASAP schedule, assuming no resource constraints. The maximum memory required to store the intermediate values is well within the available memory on an FPGA. Thus, this scheme provides a scalable, fast and inexpensive solution to the problem of single-FPGA logic simulation.

In summary, SimPLE is characterized by the following:

- the number of processing elements (PEs), each of which can be a single gate or a more complex gate (such as a combination of NAND, NOR, OR and NOR) . This is referred to as the width of SimPLE.
- the number of registers in each register file. In our current implementation, they are distributed such that each processing element contains its own register file. Such a distributed register file system allows for fast access as compared to a large general-purpose, multi-ported register file.
- the number of read ports on each register file.

- the size of each memory bank.
- the span (in terms of PEs) or number of ports of each memory bank. The number of ports in a memory bank is equal to the number of PEs the bank spans. Thus, every PE can simultaneously access the memory banks.
- the size of the memory word. This is the unit of memory access.
- the memory latency, or the number of cycles it takes to perform a memory load or a memory store.
- the interconnect latency. This refers to extra registers inserted in order to pipeline the interconnect (shown as Crossbar 4.3) between two PEs. While placing and routing an instance of SimPLE on the FPGA, the interconnect is often on the critical path; therefore inserting registers helps improve the overall clock speed at the cost of some compilation efficiency.

Apart from the above configurable parameters, the following properties of SimPLE are invariant:

- The PEs are simple two-input gates.
- Each register file can only be written by its processing element or directly from memory while performing a "memory load".
- Each register file has one extra read port by means of which it can store to memory.
- A complete interconnect (crossbar) connects every read port of every register file (except the read port for memory stores) to the input of every PE in the system.

2. Advantages of SimPLE

SimPLE has several inherent advantages over software cycle-based simulation and hardware emulators, whether FPGA-based or otherwise.

a) **Parallelism:**

SimPLE can take advantage of the large amount of parallelism present in cycle-based simulations since several processing elements can simultaneously execute in a single cycle. This is not possible in a traditional processor, i.e., a software implementation.

b) **Register and Memory Access:**

The architectural model of the simulation processor offers easy access to a large number registers, much larger than what is possible in traditional CPUs. This is important since register may be accessed in a single cycle. In the event of register spillage however, the memory banks are within close proximity, permitting fast memory accesses.

c) **Configurability:**

Since SimPLE is a virtual architecture that is configured onto a generic FPGA, the compiler has the flexibility to target the most suitable configuration of SimPLE. For instance, some applications may require more registers and memory, while others may be favored by more processing elements. Several different configurations of SimPLE may be precompiled into a library, from which the compiler can choose the best. This scheme also circumvents the cumbersome FPGA place and route process each time.

d) **Scalability:**

SimPLE is transparent to the size of the netlist, much like a software solution. A netlist is compiled into a set of instructions, any number of which may be executed on SimPLE. Larger versions of SimPLE provide better performance, while smaller ones will still simulate the netlist.

e) **Configuration Bandwidth:**

Using SimPLE, we get around the small configuration bandwidths of FPGAs by using the data I/O pins for instructions.

f) **Partitioning netlists**

The netlist can be partitioned if it is too large to fit within the board memory, and each portion transferred separately to maintain scalability.
The number of instructions generated increases with the size of the netlist. For large netlists, there may be too many instructions to fit in the board memory. However, this does not preclude simulation, which proceeds as follows.
The set of instructions is partitioned into subsets such that each subset fits in the board memory. This partitioning of instructions is equivalent to partitioning the netlist itself. The instruction subsets are DMA'ed to the board memory separately. When the first subset is streamed through the FPGA, that portion of the netlist that corresponds to it is simulated. The second subset then replaces the first subset in the board memory, and the process continues. Between subsets, the state of the netlist being simulated is maintained.
Example: A large set of instructions I is partitioned into I1 and I2, such that I1 and I2 fit in the board memory. First, the set of simulation vectors T and I1 are DMA'ed into the board memory. For the first simulation vector t1 in T, all instructions in I1 are streamed through the FPGA. Then, I2 is DMA'ed into the board memory and replaces I1. All instructions of I2 are streamed through the FPGA. This completes simulation of vector t1. It should be noted that this affects performance since we have to DMA in the middle of simulation. However it maintains scalability of our technique.

## g) Partitioning simulation vectors

A large set of simulation vectors can be partitioned into smaller blocks and simulating each block separately on the board. For simulation, both the simulation vectors as well as the instructions must fit in the board memory. The first claim handled the case when instructions do not fit in memory.

When the simulation vectors do not fit, they may be partitioned into blocks and each block simulated separately. For instance, if a design has 1 million vectors, and the on-board memory can hold only 0.5 million (in addition to the instructions), the set of simulation vectors is broken up into 2 blocks of 0.5 million vectors each. Each block is simulated separately. This does not result in a significant decrease in performance.

## h) Making registers visible

The primary outputs of a simulation do not reflect the state of the internal registers. In order to make internal registers visible, we load and store from specific locations within the memory of SimPLE. After simulation, board-level instructions extract the register values from these memory locations. It should be noted that (a) the actual location of the memory on SimPLE where the registers are is not important, i.e., it may be any location. As long as the compiler and tools are aware of where the registers are stored, their values may be extracted using board-level instructions and thereby made visible. (b) Board-level instructions are different from the instructions generated by the compiler. They perform 4 functions:

(i) put a simulation vector into the FPGA, (ii) put a compiler instruction into the FPGA, (iii) get the result from the FPGA and (iv) get the register values from the FPGA.

## i) Interfacing to a generic simulator

The simulation processor can be interfaced with a generic software simulator. We interface the simulation processor to a generic software simulator by switching the state of a design. For instance, in the middle of event-driven simulation using a software simulator, the user can switch the entire state of the circuit being simulated to SimPLE, perform functional simulation for a large number of vectors, and switch the final state back to the software simulator. Thus, SimPLE can be a transparent back-end accelerator to the software simulator.

It should be noted that the switching of state is achieved using the technique to make registers visible.

## j) Two-valued and four-valued simulation

In order to perform 4-valued simulation, every wire in the above simulation processor is 2-bit wide. The 2-bit wide wires can represent the 4 states 0,1,X and Z. The overall architecture of the simulation processor remains the same.

## IV.C. Architecture for RTL-circuits

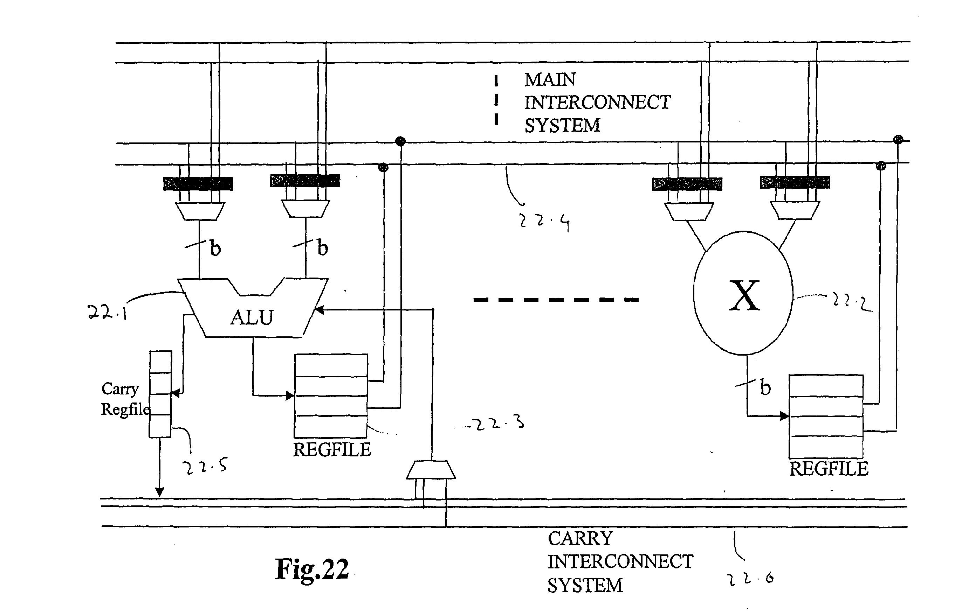

The disclosed techniques can be extended for RTL circuits without much difficulty as shown in FIG. 22. The architecture the simulation processor for acceleration of simulation of register transfer level (RTL) circuits includes an array of Arithmetic Logic Units (ALUs) (one of which is shown as 22.1), each b-bits wide, and capable of additions, subtractions, sign extensions, comparisons and bitwise Boolean operations. It also includes an array of signed multipliers (one of which is shown as 22.3), each producing a b-bit result. A distributed register file system 22.3 located within close proximity of the processing elements, is provided. It has a limited number of read and write ports and access times equal to the interconnect latency. An interconnect system 22.4 consisting of b-bit crossbar lines connecting all the distributed register files is further provided. A separate bit-wide register file 22.5 for each ALU is provided to hold carry values from ALU operations. A pipelined carry-chain crossbar interconnect 22.6 connects the bit-wide carry register files together to enable pipelined carry propagation across ALUs. A distributed memory system is located within close proximity of the ALUs. An interface from the above architecture to the external memory is located on the board, the interface consisting of instructions and opcodes that specify reading and writing of vectors and operations.

## IV.D. Compiler

### 1. Definitions

Before discussing the compiler in detail, we define some commonly used terms.

A design is a gate-level netlist being simulated. It could represent, for instance, a fully self-contained piece of hardware or a part of a larger netlist whose simulation needs to be accelerated. The set of values comprising the primary inputs of a design represents the simulation vector. In order to verify the functionality of a design, several simulation vectors are typically used. For each vector, an output vector or result vector is obtained.

A design is represented by a directed graph. The nodes of the graph correspond to the hardware functional blocks in the design. A node can have multiple inputs but at most one output. The input ports of the design are nodes without inputs, while the output ports of the design are nodes without outputs. Wires, also referred to as nets, interconnect nodes. Each wire has a single source (driver) and multiple destinations (fanout), called pins.

In the context of the compiler, when a node is allocated to a particular functional resource (processing element) in a specific time-step, it is said to be scheduled. Scheduling a node requires that a processing element (PE) be free to perform the operation of the node, and at least one register accessible to that PE be free to store the output of the node. It also requires that the inputs of the node be successfully connected to their sources using the interconnect and register ports of the register files. The latter is referred to as input routing.

A node is always scheduled after all its sources, which must be scheduled in earlier time steps. Specifically, if the interconnect latency is L, then all the sources of a node must be scheduled at least L time steps earlier in order for the node itself to be scheduled in the current time-step.

A node is a said to be ready in a certain time-step if it can be scheduled in that time-step. In general, a node is ready when all of its sources have been scheduled in earlier time-steps. However, SimPLE with the interconnect and memory latency restrictions imposes further constraints on when a node is ready. If we represent the interconnect latency by IL and the memory latency by ML, node N is ready in a time step T if:

- each source node of N has been scheduled at time Ts where $T>=Ts+IL$
- for any source node of N that was loaded from memory, the load was performed at a time step Tls where $T>=Tls+IL+ML$.

At any point during the scheduling process, the set of nodes that are ready is referred to as the ready-front. The ready-front consists of two types of nodes. The first type represents the set of nodes whose sources are live registers. The second type represents the set of nodes some of whose source registers have been spilled into memory. Such nodes are referred to as nodes with stored inputs.

The length of the schedule is the total number of time-steps. The length of the schedule is also the number of instructions generated. Given a design and a set of compiled instructions, the utilization refers to the fraction of processors in the schedule that are performing an operation, memory load or a memory store. Owing to architectural constraints, several processors are usually forced to be idle resulting in a less than 100% utilization.

### 2. The Scheduling Algorithm

The compiler schedules the design with resource constraints. It maps nodes to processing elements and wires interconnecting the nodes to registers. The registers are allocated such that overall register usage is minimized and register port constraints are obeyed. When the register files are full, it selects a register to be spilled and stored into memory. These are loaded again upon demand. The scheduling algorithm is deterministic and very fast<10>.

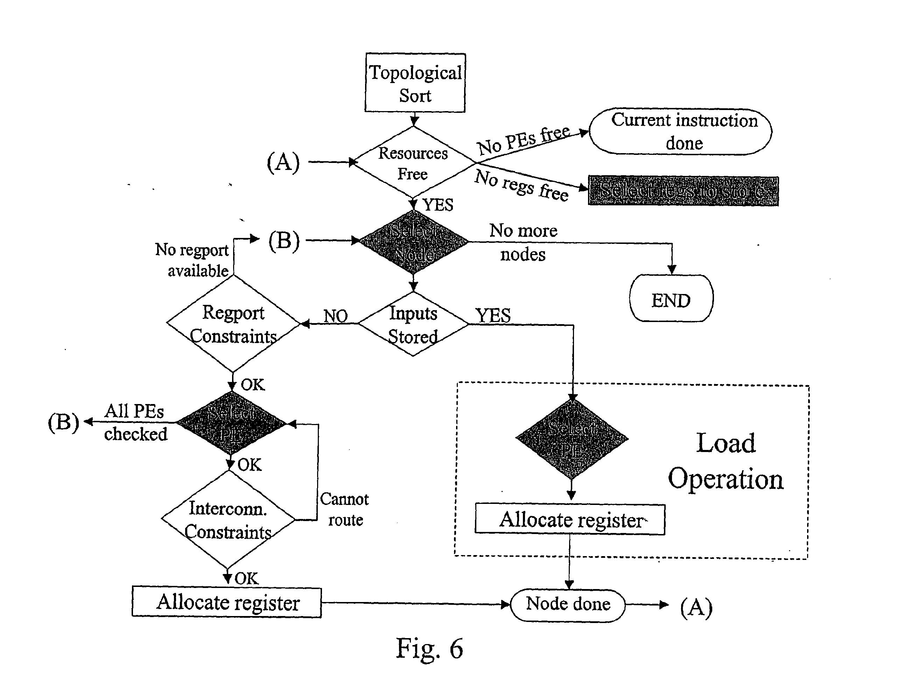

The netlist is first topologically sorted, after which buffers are inserted at several points to resolve constraints. This is described in more detail in sub-section IV.D.2.f. Subsequently, the nodes are scheduled into individual instructions. FIG. 6 shows the flow of the overall algorithm. The individual parts are described in subsequent sections.

### a) Scheduling a node

Compilation involves scheduling every node in the design, while following all architectural constraints. Scheduling a node consists of the following steps:

- Node selection:

A node is selected for scheduling from the ready-front. This selection influences the order in which future nodes are selected and is very important in order to obtain a compact schedule.

- Routing inputs:

A node from the ready-front can be scheduled in a specific time-step only if all of its inputs can be routed. Routability between a value stored in a register file and a PE's inputs is determined by the interconnect and the number of register read ports available. The complete crossbar interconnect permits a direct transfer of data between a register file of any PE and the inputs of any other PE. However, the limited number of register ports allows only a certain number of values to be read from any particular register file in a given time-step.

- PE Allocation:

Once the inputs have been routed, the node is scheduled on the processing element that has the least number of registers used. This is a greedy scheme targeted at minimizing register usage.

- Register allocation:

After PE allocation , a free register in the register file of the processing element where the node is placed is allocated to store the node's output. A free register is guaranteed to be available since the node would not have been allocated to that PE otherwise.

### b) Node Selection Heuristic

Our goal is a fast selection process fuelled by heuristics so that the length of the schedule is minimized, and the utilization maximized. Running time of the compiler increases with the optimality of the node selection heuristic.

We focus on two properties of a node N to evaluate its feasibility for scheduling:

- The number of registers freed by scheduling N. Prioritizing nodes that free a large number of registers is a simple greedy strategy to minimize register usage.
- The fanout of N. A node with a large fanout opens up more possibilities for scheduling nodes in future time-steps.

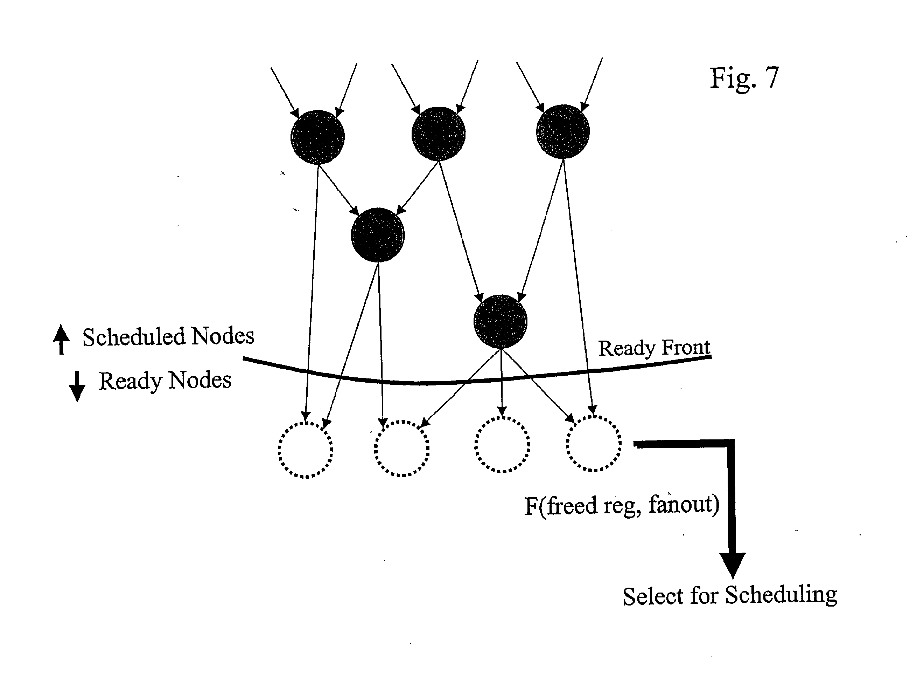

Hence nodes that free a large number of registers and have a high fanout are preferred. The node selection process is pictorially depicted in FIG. 7.

### c)    Storing Registers to Memory

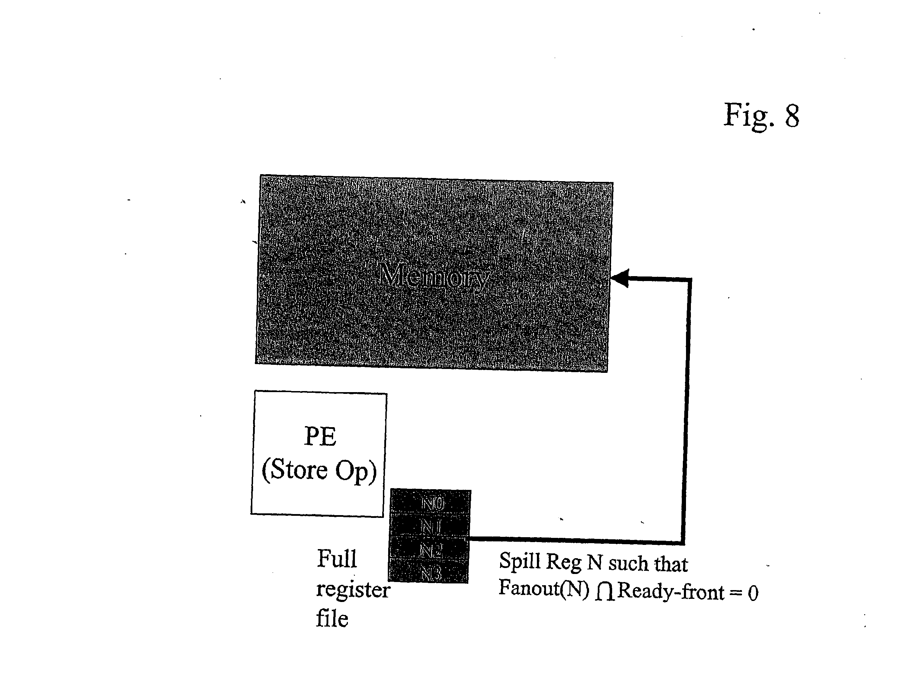

No node can be scheduled in a time step if there are no free registers. Further, a time step may be empty if no node in the ready-front satisfies the interconnect latency constraint. Under these circumstances, store operations are scheduled in every free processing element whose register file is full. A live register is freed from such register files by storing its value into the scratchpad memory. Such a live register in a register file is the output of a node N which was scheduled earlier, but some of whose fanout remain to be scheduled. At this time, N is chosen based simply based on the number of its fanout nodes that are in the ready-front. The first available node that has no fanout in the ready front is stored. If there is no node in the register file that satisfies this constraint, the node with the least fanout in the ready-front is chosen to be stored into memory. The process of storing registers is shown in FIG. 8.

### d)    Loading Registers from Memory

If an input of a node N has been scheduled but has been temporarily stored into memory, it must be loaded before N can be scheduled. Once all possible nodes without stored inputs from the ready front have been scheduled, a node with stored inputs is selected if processing elements are available. The inputs of the selected node are loaded back from memory so that the node itself may be scheduled in a future time step. A node N is selected from the list of ready nodes that have stored inputs based on the following factors:

- the number of registers that may be freed by placing N. The larger the number of registers, the better it is to load the inputs and schedule N.
- the number of fanouts of the stored inputs that are ready. This directly affects the number of nodes that may be scheduled when the input is loaded. If a node has a large number of nodes in its fanout that are ready to be scheduled, the node is a good candidate for loading.

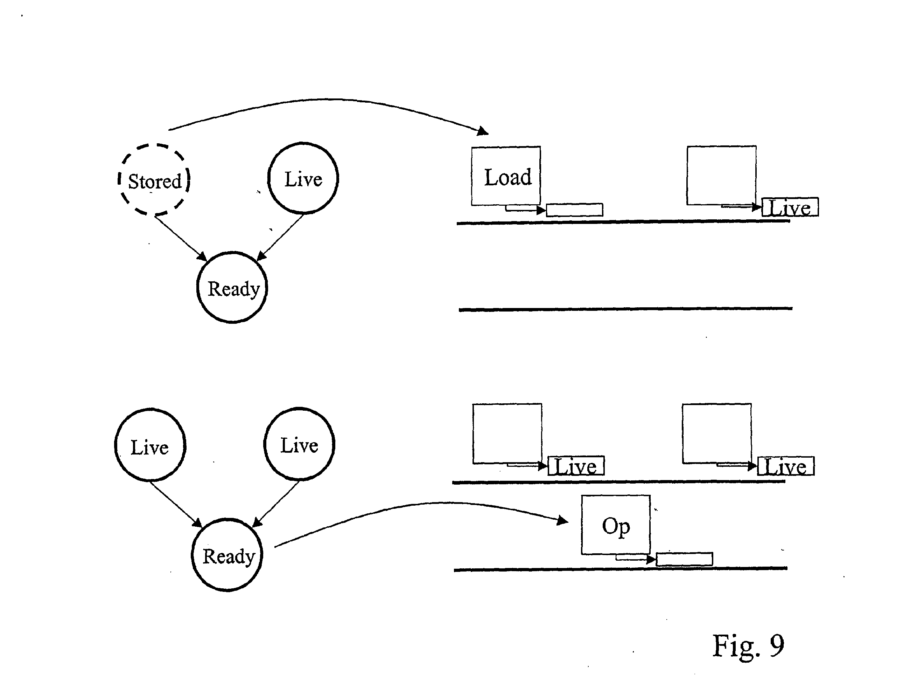

The process of loading inputs of a node in the ready-front is shown in FIG. 9. A load is scheduled first following which the ready node is scheduled in a future time-step.

### e)    Handling Registers Specified by the User

A register in the netlist to be simulated needs to be handled in a special manner. We distinguish between user cycles and processor cycles, similar to the definitions provided in <16>.

A processor cycle refers to the rate at which SimPLE operates. It may be defined as the time taken to complete a single SimPLE instruction. This is equal to the clock cycle of SimPLE on the FPGA, except in the event of the instruction word being time-multiplexed, that is, if the SimPLE instruction has more bits than the FPGA data I/O pins. In that case, the effective rate of operation is reduced. For example, if a netlist is compiled into N instructions, the instruction word size is I, the FPGA available pinout is P and the FPGA clock speed is C, then the factor of time-multiplexing F is I/P, the processor clock speed is C/F. On the other hand, a user cycle refers to time taken to fully simulate the netlist for one vector. For the above example, the user clock speed is C/(F*N).

When the input of a gate G in a netlist is a user register, then the value that must be used to evaluate the gate is the value of the register from the previous user cycle. When a register is the output of a gate G in a netlist, then the value that must be stored into the register is the value computed by G in the current user cycle. However, the value of the register from the previous user cycle must also be available if it needs to be used in the current user cycle. As a result, a user register R is scheduled in the following manner:

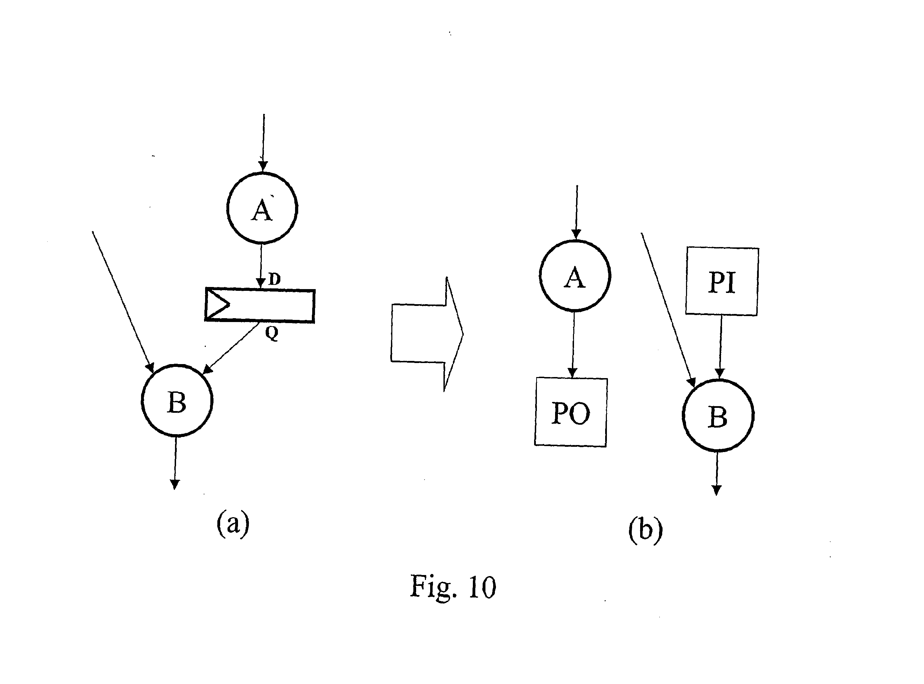

- R is broken up into two nodes: $D_R$ and $Q_R$. $D_R$ represents the input of R while $Q_R$ represents its output.
- A scheduling constraint is imposed on $D_R$: it must be scheduled in a time-step later than $Q_R$.
- When DR is scheduled, the value at its input is stored into memory. This represents the value of R from the current user cycle (to be used the next user cycle).
- When $Q_R$ is scheduled, the value is loaded from memory. This represents the value of R from the previous user cycle (to be used during the current user cycle). User-registers depicts how the compiler handles user registers. FIG. 10 shows how the compiler handles registers.

### f) Handling Primary Inputs (PIs) and Primary Outputs (POs)

Gate-level designs can have a large number of PIs and POs, sometimes of the order of several thousands of bits. In order to expedite loading of the PIs and storing of the POs, addressing of individual bits into arbitrary locations within SimPLE's memory is not done. Instead, all the PIs are loaded sequentially from consecutive memory locations. Similarly, all the POs are stored sequentially into consecutive memory locations. Further, when loading or storing from outside the FPGA (i. e., from the board memory), the PIs and POs are grouped into words (by external software) such that the size of the words matches the memory wordsize, i.e., the unit that may be read from or written to the memory. A word may then be loaded or stored every cycle, which is much faster than loading individual bits.

While these assumptions make the input-output interface of SimPLE simpler, they present constraints to the compiler. First, the compiler is more restricted in placing PIs and POs. This is due to the fact that the scratchpad memory is split into banks; each bank spans a limited range of PEs and may only be accessed by those PEs. The compiler therefore has to allocate each PI or PO to a specific memory bank based on the index of the PI or PO.

Further, since POs represent memory stores, they have to be placed in the same PE as their immediate sources (but in later time steps) so that the register may be stored. Since the POs also have to be stored into specific memory banks, this imposes a restriction on the immediate sources of the POs: they must be placed within the reach of the specific memory bank in which the PO is to be stored.

The above restrictions may render certain netlists infeasible to schedule. For instance, if PIs happen to be shorted to POs (as may happen in certain netlists after optimization), their differing indices may force them into different memory banks. Such anomalies are resolved by inserting buffers to increase scheduling flexibility at the cost of some resources.

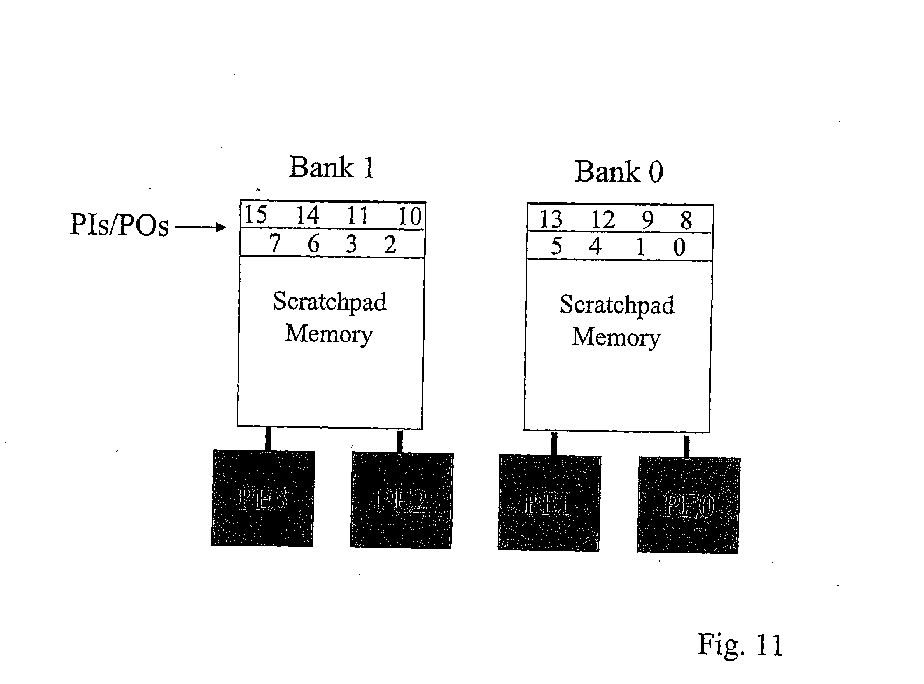

The PIs and POs are organized in memory banks within SimPLE as illustrated in FIG.11. Each memory bank has a separate dedicated portion for PIs and POs, and a general portion for use during the simulation to spill registers. The organization of PIs and POs allows each PE to read in a primary input bit (or write out a primary output bit) at the maximum memory bandwidth rate. It also precludes addressing of the bits into arbitrary memory locations: the interface software may easily assemble the PIs.

### 3. Compilation Results and Analysis

We analyze results using a combination of industrial, ISCAS and other representative benchmarks. For every result in this work, we use 4 industrial benchmarks (NEC1-4), the integer and the microcode units of the PicoJava processor (IU and UCODE), and 6 large gate-level combinational and sequential netlists selected from ISCAS89, ITC99<20>, and from common bus and USB controllers. The benchmarks range in size from 31,000 to 430,000 2-input gates.

### a) Storage Requirement

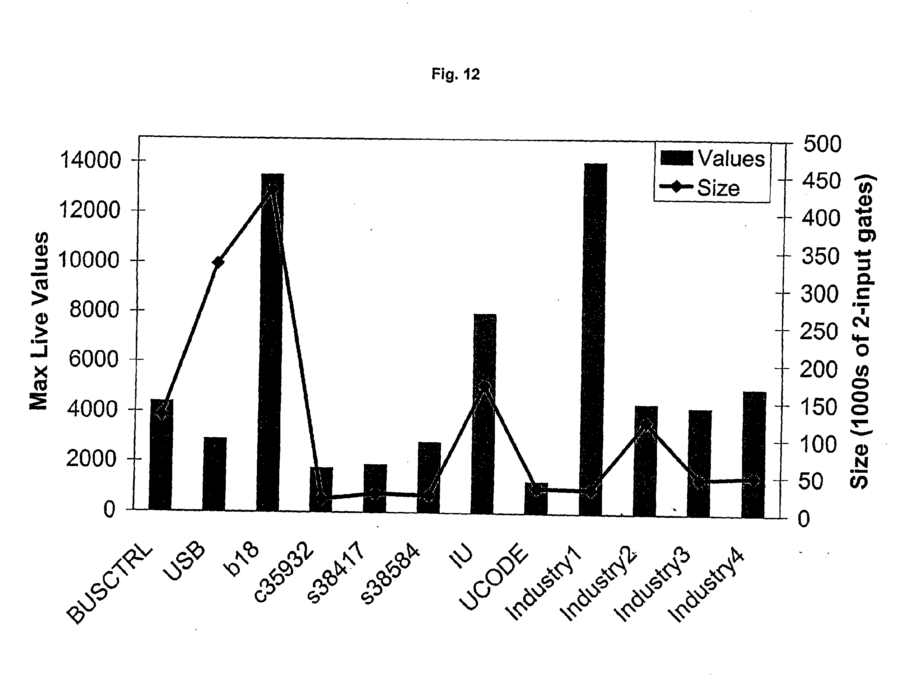

The registers and memory are used to store temporary values during simulation. A circuit with too many such values cannot be simulated using SimPLE if the registers and memory are insufficient. However, memories are quite large in modern FPGAs . FIG. 12 shows that the amount of storage required when targeting a SimPLE architecture with 48 processors, 64 registers and 2 readports per register file is well within the available memory on an FPGA.

### b) Instruction Generation Complexity

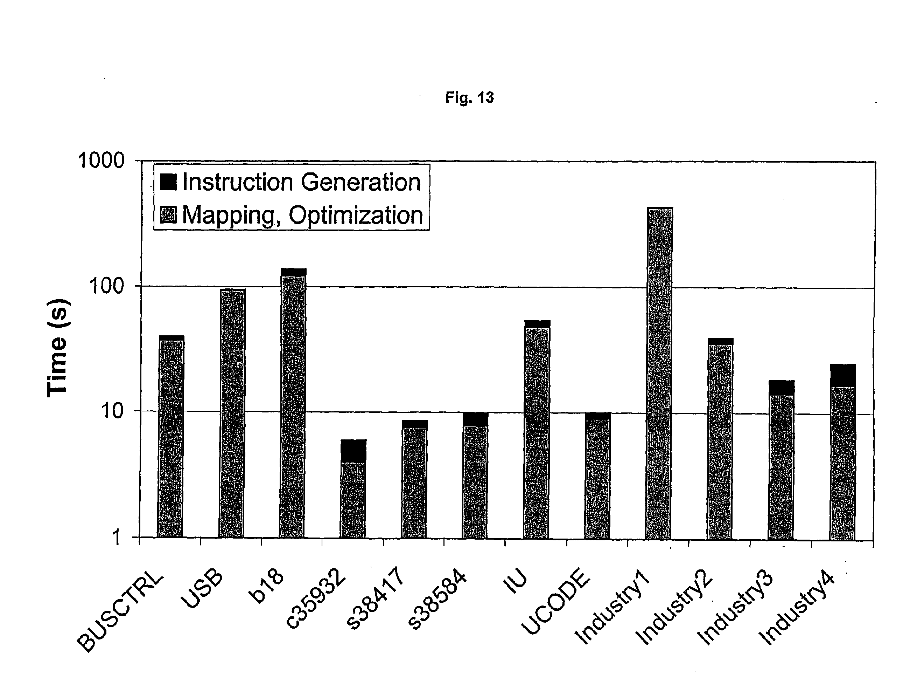

For a netlist with n nodes, the ready front has $O(n)$ nodes. In order to select a node from the ready front, the heuristics of Section IV.D.2.b require the number of freed registers, the fanout and the number of fanout that are part of the ready front, all of which may be pre-computed. Thus, the time required to select a node is $O(n)$. We effectively reduce this to constant time in the following manner. At the start of a time-step, heuristics for all nodes in the ready-front are pre-computed and inserted into a table indexed by their heuristic value. The ith entry in the table contains all the nodes in the ready front whose heuristic evaluates to i. Thus, selecting nodes takes $O(1)$ time. FIG. 13 illustrates how fast the compiler is when running on a 440MHz UltraSparc10.

### c) Effects of SimPLE Parameters on Compilation Efficiency

Now we evaluate the effects of important SimPLE parameters on the number of instructions produced by the compiler. The size of each memory bank was fixed at 16K bits and the memory word size was 4 bits, both of which are compatible with a block-RAM on a Virtex-II FPGA. The memory and interconnect latencies were varied depending on the instruction size. Pipelining the interconnect and memory results in a better FPGA clock speed but lowers the compilation efficiency. From our experiments, we found that an interconnect and memory latency of 2 cycles was necessary to obtain reasonable clock speeds on the FPGA. These latencies are in terms of FPGA cycles. Therefore, if the processor cycle is larger than an FPGA cycle (i.e., if the SimPLE instruction requires time-multiplexing), the compiler assumes both the interconnect and memory latencies to be 1. This is because successive instructions are separated by a processor cycle which is at least 2 FPGA cycles.

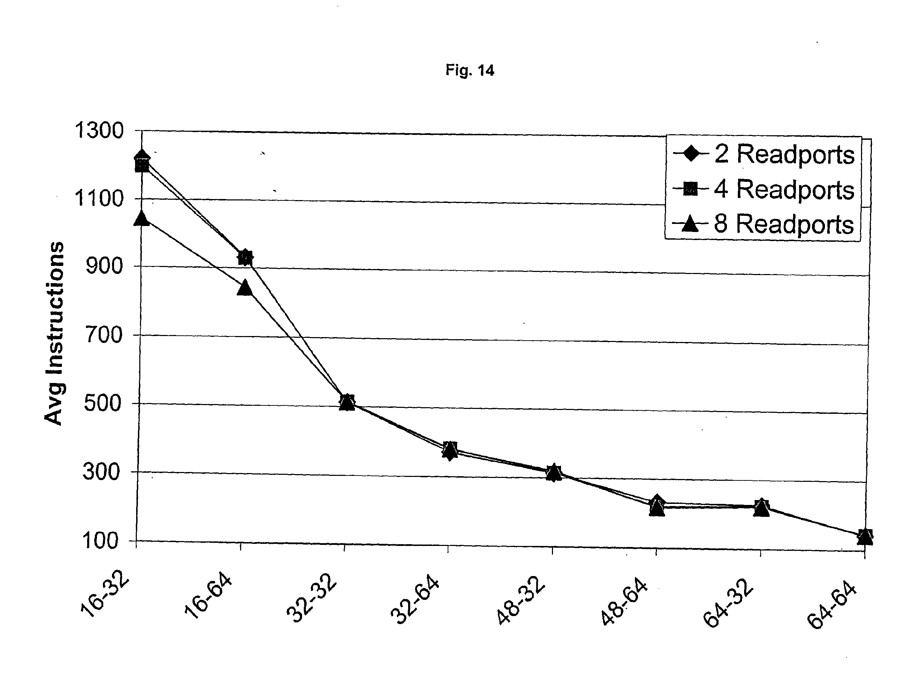

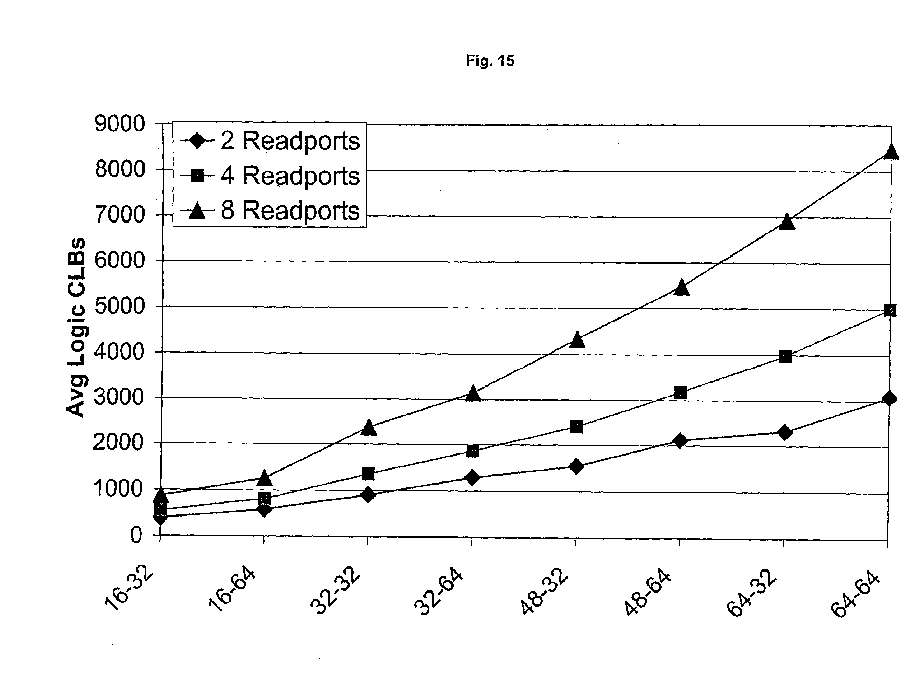

FIG. 14 shows how the average number of instructions produced by the compiler varies with the the number of processors, registers and register readports in SimPLE. The significant result is that more than 2 register ports make little difference when there are 32 or more processors. This is explained by the fact that all netlists are mapped to 2-LUTs during compilation, and sufficient parallelism exists with 32 processors to minimize overlap of values on the same processor (overlapping values on a single processor require the use of multiple readports). FIG. 15 shows that extra readports also consume a large number of CLBs (estimated on a Xilinx Virtex-II FPGA).

Hence we confine ourselves to SimPLE architectures with 2 readports. In addition, the memory configuration and the interconnect and memory latencies are also fixed as described above.

### IV.E.    FPGA Synthesis

Prior to simulation, SimPLE must be configured onto the FPGA. This is done only once, after which an arbitrary number of simulations may be performed. The configuration bits for several SimPLE architectures may be produced beforehand and stored in a library. Thus, the time taken to place and route SimPLE on the FPGA does not affect the simulation speed. However, the FPGA clock speed affects the simulation speed. Therefore, it is important to place and route SimPLE on an FPGA and achieve a high clock speed. This section describes our FPGA place and route procedure.

An HDL generator generates a behavioral description of SimPLE with a specific set of parameters, namely the number of processors, memory size, etc. It can also generate extra hardware to time-multiplex the SimPLE instruction if required. This description is synthesized using Synopsys' FPGA Express and mapped, placed and routed on a Virtex-2 FPGA using the Xilinx Foundation 4.1i.

### 1.    FPGA Place and Route Methodology for SimPLE

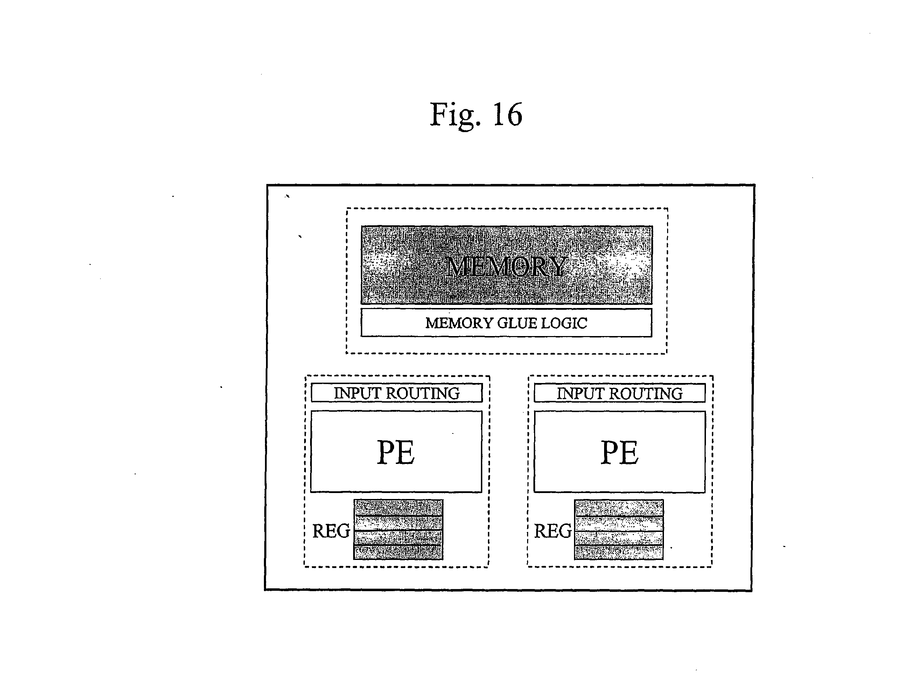

Placement on an FPGA is extremely important in order to achieve good routability. It has been shown that correct placement of modules prior to routing can reduce congestion and enhance the clock speed considerably<12,4>. We use a regularity-driven scheme to obtain a good placement. Every instance of SimPLE inherently has a high degree of regularity since the processing elements, memory blocks and register files are all identical to each other. The hierarchy of SimPLE, including all the regular units, is shown in FIG. 16.

Our FPGA place and route methodology involves the following four steps: (i) identification of the best repeating unit in the design, (ii) compact pre-placement of the repeating unit as a single (relatively placed) hard macro, (iii) placement of the entire design using the macros and (iv) overall final routing.

From among the several macros possible in FIG. 16, we experimentally found that the largest one (i. e., the top-level macro) was the best. The large macro had the best compaction ratio and relatively less IO. Once identified, a macro is synthesized, mapped to the FPGA CLBs and then placed. The overall description of SimPLE is instantiated in terms of the macro, mapped, placed and routed. No optimization is performed across the boundaries of preplaced macros. The entire macro flow has been fully automated using scripts that interact with the FPGA tools.

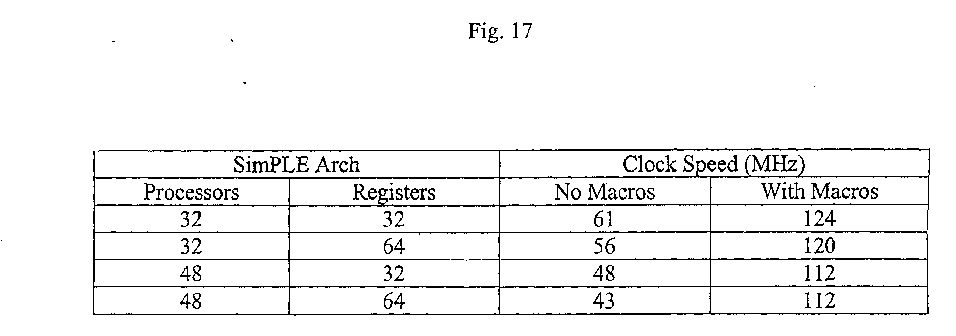

Table 1 shown in FIG. 17 compares FPGA clock speeds with and without our macro strategy. All experiments were performed using the latest Xilinx Foundation 4.1i. We see improvements of upto 3x with our approach. Compacting the structure shown in FIG. 16 into macros forces a better distribution of placed components on the FPGA, and also makes the clock speed less sensitive to the number of registers in a PE.

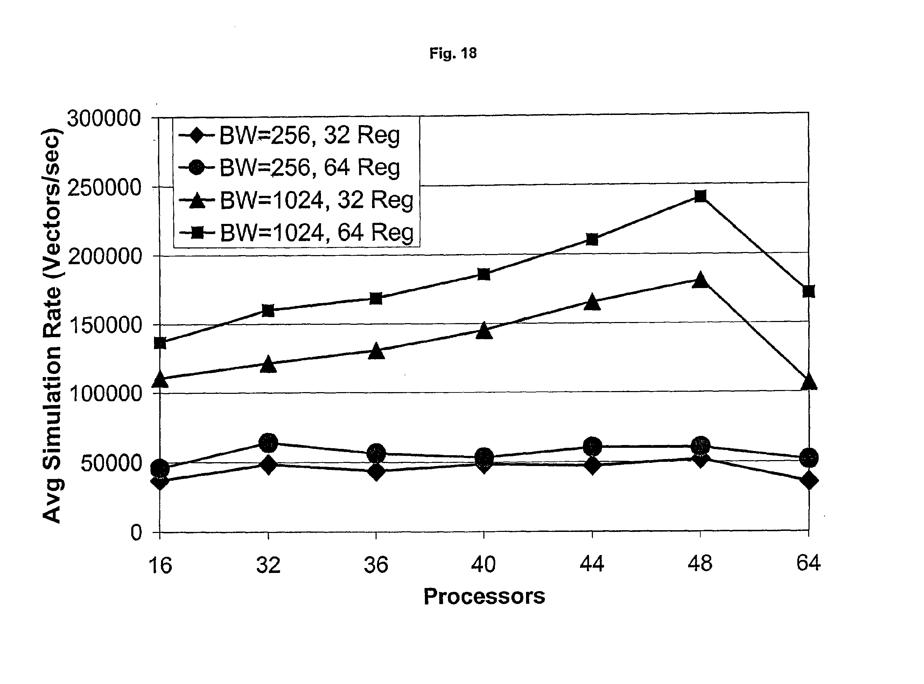

Using the FPGA clock cycle, along with the number of compiled instructions and the instruction width, we can compute the simulation rate using Equation 2. FIG. 18 shows the simulation rate in vectors per second for various SimPLE architectures for two values of the FPGA-memory bus width: 256 and 1024. The architecture with 48 processors is clearly the best when the FPGA-memory bus is 1024 bits wide. Wider architectures have wider instructions that need to be time-multiplexed more, and are therefore not necessarily better. With a smaller FPGA-memory bus width, several architectures were close. This indicates that the instruction width offsets gains provided by the wider architectures when the FPGA-memory bus width is small.

### IV.F. Experiments, Analysis and Discussion

In this section, we present actual speedups resulting from an implementation of SimPLE on a large Virtex-II FPGA as well as our first prototype on a generic board.

### 1.    Speedup on Virtex-II

Based on the results, we synthesized a version of the SimPLE processor with 48 processing elements, 64 registers per processing element, 2 register read ports per register file, a distributed memory system consisting of banks of 16Kbits each spanning two processing elements, a memory word size of 4 bits and an interconnect latency of 2 on an 8-million gate Virtex-II FPGA (XV2V8000). We used Xilinx's Foundation tools.

### a)    Comparison to Cycle-based Simulation

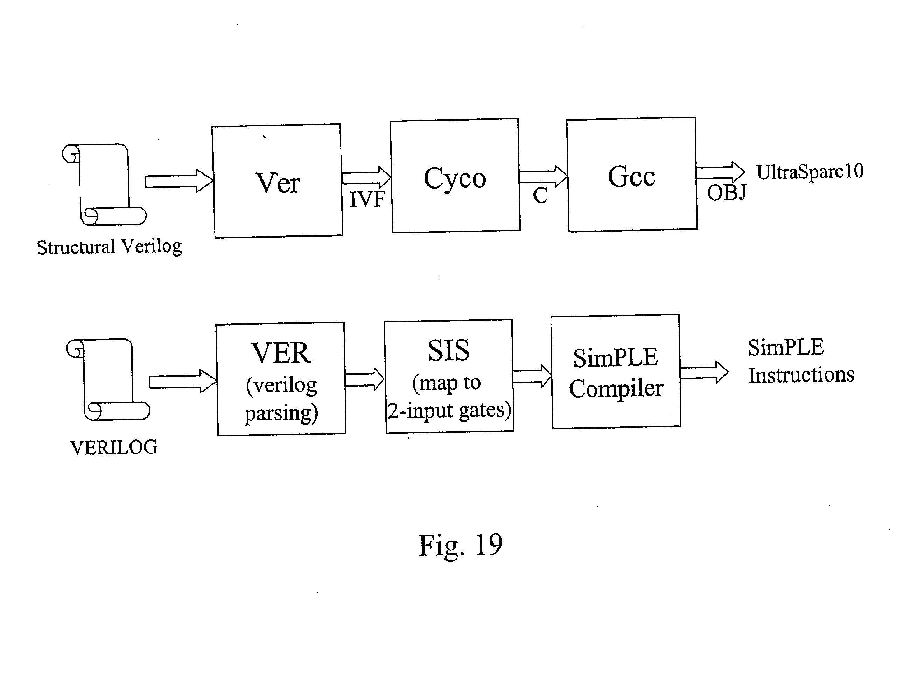

We used the Ver verilog compiler and Cyco as our cycle-based simulator. Ver reads in structural verilog and generates an intermediate form called IVF. Cyco reads in IVF and generates straight line C code representing the structural verilogx. FIG. 19 shows our experimental toolflow for cycle-based simulation as well as for SimPLE. We compiled and ran the C code on an UltraSparc 10 system with 1GB RAM containing a SparcV9 processor running at 440MHz. It may be noted that the time for compiling the generated C code is large (around a few hours). This is another advantage of SimPLE which has small compile times.

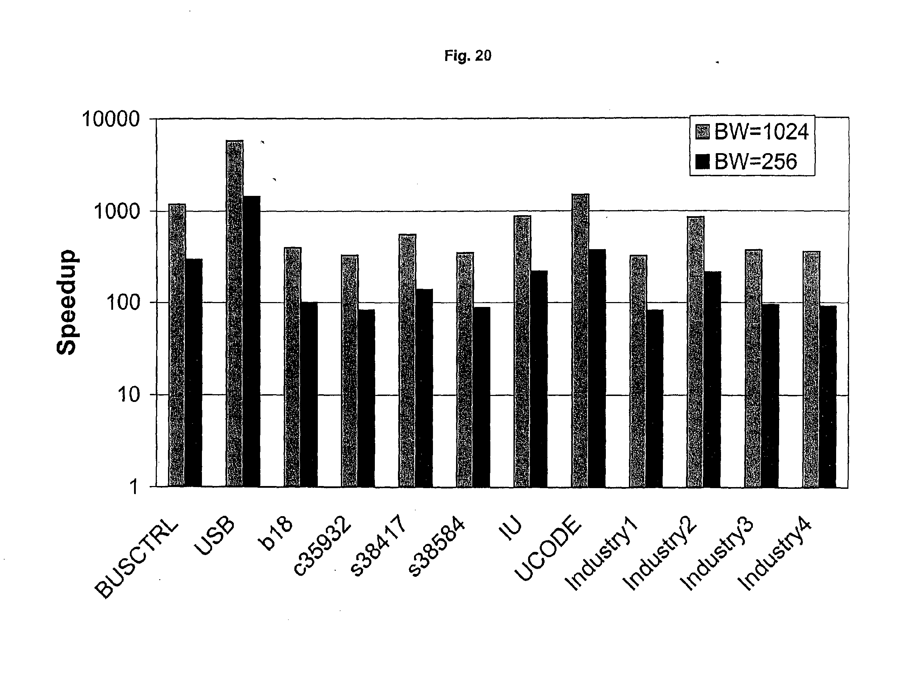

FIG. 20 shows the speedup obtained by SimPLE with 48 processors and 64 registers running at 100MHz (restricted since most boards run at 100 MHz) over a cycle based simulator running on an UltraSparc 440MHz workstation. The right column for each benchmark indicates the speedup achieved if the FPGA-memory bus width is 1024 bits, while the smaller left column indicates the speedup for a FPGA-memory bus width of 256 bits. The speedups range between 200x and 3000x for a memory-FPGA bus width of 1024 bits and decrease to 75-1000x for a memory-FPGA bus width of 256 bits.

### b) Comparison to Zero-delay Event-driven Simulation

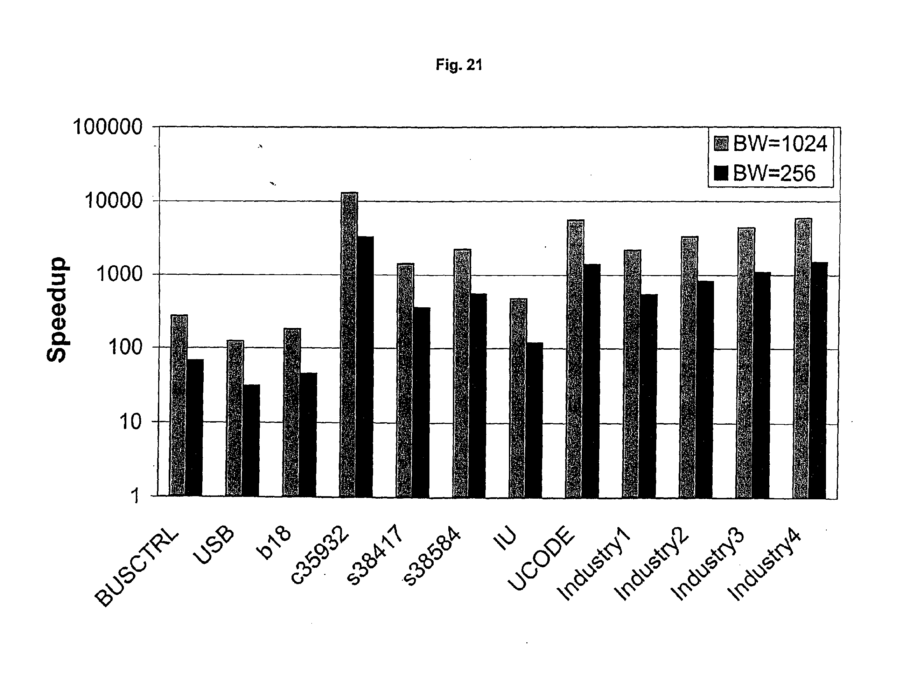

For this comparison, we used ModelSim version 5.3e with zero-gate delays. Each of our benchmarks was optimized exactly in the same fashion as for SimPLE and then loaded into ModelSim for event-driven simulation. Once again, we used a 440MHz UltraSparc-10 for this purpose. FIG. 21 shows the speedups obtained for the same benchmarks. The speedups range between 300-6000x for a FPGA-memory bus width of 1024 bits and decrease to 75-1500x when the FPGA-memory bus width reduces to 256 bits .

### 2. Speedup using the prototype

We implemented a prototype using a generic FPGA board (ADC-RC1000) from AlphaData (www.alphadata.co.uk). The board had a Xilinx Virtex-E 2000 FPGA with an FPGA-memory bus width of 128 bits. We have a fully working simulation environment along with a graphical user interface that allows the user to compile and simulate a netlist, and view selected signals. We measured speedups obtained on the small prototype board for two designs. One was a 400,000-gate sequential benchmark, and the other a portion of the pipeline datapath of the PicoJava processor. For both of these, the protytype board was about 30x faster than ModelSim, and 12x faster than the cycle-based simulator.

### 3. Where does the speedup come from?

The primary reasons for the speedups are (i) the parallelism (ii) large number of registers and memory in SimPLE (iii) high bandwidth between the FPGA and board memory and (iv) high FPGA clock speed. Superscalar processors, using dynamic parallelism techniques, typically execute 2-3 instructions per cycle. In SimPLE however, we can execute as many instructions every cycle as there are processing elements. The large number of registers in SimPLE (32 or more dedicated to each processing element) reduces memory operations.

Further facilitating the simulation process is the high bandwidth between the FPGA and the board memory that allows quick transfer of the wide SimPLE instructions. Finally, the regularity of the SimPLE architecture makes a high-speed implementation on an FPGA possible. As FPGAs grow in size, larger SimPLE architectures can be implemented improving the speedups.

Other modifications and variations to the invention will be apparent to those skilled in the art from the foregoing disclosure and teachings. Thus, while only certain embodiments of the invention have been specifically described herein, it will be apparent that numerous modifications may be made thereto without departing from the scope of the invention.

### Claims

**1.** A hardware acceleration system for functional simulation comprising:

a generic circuit board including logic chips, and memory,

wherein the circuit board is capable of plugging onto a computing device and the system being adapted to allow the computing device to direct DMA transfers between the circuit board and a memory associated with the computing device,
wherein the circuit board is capable of being configured with a simulation processor, said simulation processor capable of being programmed for at least one circuit design.

**2.** The system of claim 1, wherein an FPGA is mapped with the simulation processor.

**3.** The system of claim 1, wherein a netlist for a circuit to be simulated is compiled for the simulation processor.

**4.** The system of claim 1, wherein the simulation processor further includes:

at least one processing element; and
at least one register file with one or more registers corresponding to said at least one processing element.

**5.** The system of claim 4, wherein the simulation processor further includes a distributed memory system with at least one memory bank.

**6.** The system of claim 5, wherein said at least one memory bank serves a set of processing elements and their associated registers.

**7.** The system of claim 5, wherein a register is capable of being spilled onto the memory bank.

**8.** The system of claim 4, further including an interconnect system that connects said at least one processing element with other processing elements.

**10.** The system of claim 4 wherein the processing element is capable of simulating any 2-input gate.

**11.** The system of claim 4, wherein the processing element is capable of performing RT-level simulation.

**12.** The system of claim 8, wherein the connection is made through the registers.

**13.** The system of claim 12, wherein the interconnect network is pipelined.

**14.** The system of claim 8, wherein the register file is located in proximity to its associated processing element.

**15.** The system of claim 5, wherein the distributed memory system has exclusive ports corresponding to each register file.

**16.** The system of claim 3, wherein the system is capable of processing a partition of the netlist at a time when the netlist is does not fit the memory on the board.

**17.** The system of claim 16, wherein the system is capable of simulating the entire netlist by sequentially simulating its partitions.

**18.** The system of claim 3, wherein the system is capable of processing a subset of simulation vectors that are used to test the circuit.

**19.** The system of claim 18, wherein the system is capable of simulating the entire set of simulation vectors by sequentially simulating each subset.

**20.** The system of claim 1, wherein the acceleration system is capable of being interchangeably used with a generic software simulator with the ability to exchange the state of all registers in the design

**21.** The system of claim 1, wherein both 2-valued and 4-valued simulation can be performed on the simulation processor.

**22.** The system of claim 1, further including an interface and opcodes, wherein said opcodes specify reading, writing and other operations related to simulation vectors.

**23.** The system of claim 1 wherein the simulation processor further includes:

at least one arithmetic logic unit (ALU);
zero or more signed multipliers;
a distributed register system with least one register each associated with said ALU and said multiplier.

**24.** The system of claim 23, wherein said system includes a carry register file for each ALU, wherein a width of the register is same as a width of the corresponding register.

**25.** The system of claim 24, further including a pipelined carry-chain interconnect connecting the registers.

**26.** A method for performing logic simulation for a circuit comprising:

a) compiling a netlist corresponding to the circuit to generate a set of instructions for a simulation processor;
b) loading the instructions onto an on-board memory corresponding to the simulation processor;
c) transferring a set of simulation vectors onto the on-board memory;
d) streaming a set of instructions corresponding to the netlist to be simulated onto an FPGA on which the simulation processor is configured;
e) executing the set of instructions to produce a set of result vectors; and
f) transferring the result vectors onto a host computer.

**27.** The method of claim 26, wherein if an instruction is wider than a bus connecting the on-board memory to the FPGA, the instruction is time-multiplexed.

**28.** A method of compiling a netlist of a circuit for a simulation processor, said method comprising:

a) representing a design for the circuit as a directed graph, wherein nodes of the graph correspond to hardware blocks in the design;
b) generating a ready-front subset of nodes that are ready to be scheduled;

c) performing a topological sort on the ready-front set;

d) selecting a hitherto unselected node;

e) completing an instruction and proceeding to a new instruction if no processing element is available;

f) selecting a processing element with most free registers associated with it to perform an operation corresponding to the selected node;

g) routing operands from registers to the selected processing element; and

i) repeating steps d-h until no more nodes are left unselected.

**29.** The method of claim 28 wherein a node is selected based on a selection heuristic including a largest number of registers freed by scheduling the node and a largest number of fanout of the node.

**30.** The method of claim 28, wherein when a register file is full a register is selected to be spilled and stored onto memory to be loaded when a demand arises.

**31.** The method of claim 30, wherein if in step f no registers are available, then registers are spilled to the memory banks

**32.** The method of claim 30 wherein a register is selected to be spilled is a register that is an output of a node scheduled earlier based on a selection heuristic including a largest number of registers freed by scheduling the node and a largest number of fanout of the node.

**33.** A hardware functional simulator including:

a circuit board including programmable logic chips, and memory,

wherein the circuit board is capable of plugging onto a computing device and the system being adapted to allow the computing device to interface between the circuit board and a memory associated with the computing device, and

wherein the programmable logic chips are capable of being configured as a simulation processor, said simulation processor capable of being programmed for at least one circuit design to be simulated.

**34.** A circuit board including programmable logic chips, and memory,
wherein the circuit board is capable of plugging onto a computing device and the system being adapted to allow the computing device to interface between the circuit board and a memory associated with the computing device, and

wherein the programmable logic chips are capable of being configured as a simulation processor, said simulation processor capable of being programmed for at least one circuit design to be simulated.

**35.** A computing device provided with a circuit board including programmable logic chips, and memory, the circuit board being plugged into the computing device and the system being adapted to allow the computing device to interface between the circuit board and a memory associated with the computing device,

wherein the programmable logic chips are capable of being configured as a simulation processor, said simulation processor capable of being programmed for at least one circuit design to be simulated.

**36.** Apparatus for performing logic simulation for a circuit, comprising:

a) means for receiving a netlist corresponding to the circuit to generate a set of instructions for a simulation processor;

b) means for loading the instructions onto an on-board memory corresponding to the simulation processor;

c) means for transferring a set of simulation vectors onto the on-board memory;

d) means for streaming a set of instructions corresponding to the netlist to be simulated onto an FPGA (field-programmable gate array) on which the simulation processor is configured; and

e) means for executing the set of instructions to produce a set of result vectors.

**37.** Apparatus for compiling a netlist of a circuit for a simulation processor, comprising:

a) means for representing a design for the circuit as a directed graph, wherein nodes of the graph correspond to hardware blocks in the design; and

b) means for generating a ready-front subset of nodes that are ready to be scheduled; performing a topological sort on the ready-front set; selecting a hitherto unselected node; completing an instruction and proceeding to a new instruction if no processing element is available; selecting a processing element with most free registers associated with it to perform an operation corresponding to the selected node; and routing operands from registers to the selected processing element; and for repeating this step b) until no more nodes are left unselected.

**EP 1 349 092 A2**

**38.** A computer program constructed so that when operated on a computer it configures the computer to execute the method of any of claims 26 to 32.

Fig. 1

SimPLE Intermediate Arch   2.6

Registers

| Memory | Memory |

INTERCONNECT

| PE | PE | PE | PE |

2.31  2.32  2.83  2.34

Efficient FPGA Mapping

Memory 2.1

FPGA   DMA/ PCI CTRL   PCI BUS

2.2

Module test;
  input I;
  output o;
  ......
  ......

Compiler → INSTRUCTIONS

Stream to FPGA

2.5

2.4

Fig. 2

Fig. 3

MULTI-MILLION GATE CIRCUIT — 32

COMPILER — 25

API — 3.1

SimPLE Instructions

CPU ↔ Main Memory

DMA

SIM. VECTORS

RESULTS

PCI Interface

On-board Memory — 2.1

FPGA — 2.2

SimPLE — 2.6

2.4   3.2

EP 1 349 092 A2

Fig. 4

Fig. 5

```
                    ┌──────────────┐
                    │ Topological  │
                    │    Sort      │
                    └──────────────┘
                           │
                           ▼
                    ╱───────────╲        No PEs free      ╭──────────────────╮
        (A) ──────▶│  Resources  │──────────────────────▶│ Current instruction│
                   │    Free     │                        │       done        │
                    ╲───────────╱        No regs free     ╰──────────────────╯
                           │         ──────────────────▶  ▓▓▓▓▓▓▓▓▓▓▓▓▓▓▓▓▓
                           │ YES                          ▓ Select regs to store ▓
                           ▼
    No regport    ╱─────────╲      No more
    available     ▓ Select  ▓      nodes
         ┌───────▶▓  Node   ▓──────────────────────┐
         │        ╲─────────╱                       │
         │             │                            ▼
         │             ▼                        ╭───────╮
    ╱─────────╲   NO  ╱─────────╲   YES         │  END  │
    │ Regport │◀──────│ Inputs  │──────┐        ╰───────╯
    │Constraints      │ Stored  │      │
    ╲─────────╱       ╲─────────╱      │
         │ OK                          │
         ▼                             ▼
All PEs ▓▓▓▓▓▓▓                   ▓▓▓▓▓▓▓▓
checked ▓Select ▓                 ▓ Select ▓   Load
(B)◀────▓  PE   ▓◀──────┐         ▓  PE    ▓   Operation
        ▓▓▓▓▓▓▓▓        │         ▓▓▓▓▓▓▓▓
         │ OK            Cannot        │
         ▼              route          ▼
    ╱─────────╲         │        ┌──────────────┐
    │Interconn.│────────┘        │Allocate register│
    │Constraints                 └──────────────┘
    ╲─────────╱                         │
         │ OK                           │
         ▼                              ▼
    ┌──────────────┐            ╭───────────╮
    │Allocate register│───────▶ │ Node done │───▶ (A)
    └──────────────┘            ╰───────────╯
```

Fig. 6

Fig. 7

Scheduled Nodes

Ready Nodes

Ready Front

F(freed reg, fanout)

Select for Scheduling

EP 1 349 092 A2

PE
(Store Op)

Full
register
file

N0
N1
N2
N3

Memory

Spill Reg N such that
Fanout(N) ∩ Ready-front = 0

Fig. 8

Fig. 9

(a)

(b)

Fig. 10

Fig. 11

Fig. 12

Fig. 13

Fig. 14

Fig. 15

## Fig. 16

EP 1 349 092 A2

Fig. 17

| SimPLE Arch | | Clock Speed (MHz) | |
|---|---|---|---|
| Processors | Registers | No Macros | With Macros |
| 32 | 32 | 61 | 124 |
| 32 | 64 | 56 | 120 |
| 48 | 32 | 48 | 112 |
| 48 | 64 | 43 | 112 |

EP 1 349 092 A2

Fig. 18

EP 1 349 092 A2

Ver $\xrightarrow{\text{IVF}}$ Cyco $\xrightarrow{\text{C}}$ Gcc $\xrightarrow{\text{OBJ}}$ UltraSparc10

Structural Verilog

VER
(verilog
parsing) → SIS
(map to
2-input gates) → SimPLE
Compiler → SimPLE
Instructions

VERILOG

Fig. 19

**Fig. 20**

EP 1 349 092 A2

Fig. 21

EP 1 349 092 A2

MAIN
INTERCONNECT
SYSTEM

22.4

b          b

22.1

ALU          X          22.2

Carry
Regfile          b

22.5          REGFILE          22.3

REGFILE

**Fig.22**          CARRY
INTERCONNECT
SYSTEM          22.6

EP 1 349 092 A2